# EUROPÄISCHE PATENTSCHRIFT

(11) **EP 3 383 558 B1**
(45) Veröffentlichungstag und Bekanntmachung des Hinweises auf die Patenterteilung: **12.02.2020**
(21) Anmeldenummer: 16816684.1
(22) Anmeldetag: 20.12.2016
(51) Int. Cl.: B07C 5/342, G01N 1/08, A01C 1/02, B07C 5/38

(54) **PROBENVORRICHTUNG ZUR EINFÜHRUNG EINES VEREINZELTEN SAATGUTKORNES IN EINE MESSEINRICHTUNG SOWIE SYSTEM UND VERFAHREN ZUM SORTIEREN EINER VIELZAHL VON SAATGUTKÖRNERN UND DESSEN VERWENDUNG**
SAMPLING DEVICE FOR INTRODUCING INDIVIDUALIZED SEED GRAINS INTO A MEASURING DEVICE, SYSTEM AND METHOD FOR SORTING A PLURALITY OF SEED GRAINS, AND USE THEREOF
SYSTÈME D'ÉCHANTILLONNAGE SERVANT À INTRODUIRE DANS UN DISPOSITIF DE MESURE UN GRAIN DE SEMENCE SÉPARÉ, SYSTÈME ET PROCÉDÉ DE TRI D'UNE PLURALITÉ DE GRAINS DE SEMENCE SÉPARÉS, ET UTILISATION DESDITS SYSTÈMES

(30) Priorität: 21.12.2015 DE 102015226349
(43) Veröffentlichungstag der Anmeldung: 10.10.2018
(73) Patentinhaber: Universität Hohenheim, 70599 Stuttgart (DE)
(72) Erfinder: MELCHINGER, Albrecht Eugen, 70599 Stuttgart (DE); MAUCH, Franz-Josef, 70599 Stuttgart (DE)
(74) Vertreter: Altmann Stößel Dick Patentanwälte PartG mbB
(86) Internationale Anmeldenummer: PCT/EP2016/081844
(87) Internationale Veröffentlichungsnummer: WO 2017/108740

(56) Entgegenhaltungen:
- EP-A2- 0 411 932
- US-A1- 2003 188 998
- US-A1- 2006 042 528

## Beschreibung

Die vorliegende Erfindung betrifft eine Probenvorrichtung zur Einführung eines vereinzelten Saatgutkornes in eine Messeinrichtung, welche für Untersuchungen an Saatgutkörnern eingerichtet ist. Die vorliegende Erfindung betrifft weiterhin ein System und ein Verfahren zum Sortieren einer Vielzahl von Saatgutkörnern sowie die Verwendung des Systems für eine automatisierte Hochdurchsatz-Sortierung der Saatgutkörner unter Einsatz der Probenvorrichtung.

### Stand der Technik

Viele Anwendungen in der Pflanzenforschung und -züchtung erfordern schnelle, möglichst zerstörungsfreie Untersuchungsmethoden zur exakten und präzisen Bestimmung von Eigenschaften einzelner Samenkörner aus einer großen Anzahl. Ein Beispiel hierfür besteht in der Ermittlung eines Ölgehalts der Samenkörner. Aus Silvela, L., Rodgers, R., Barrera, A., und Alexander, D. E. (1989), Effect of selection intensity and population size on percent oil in maize, Zea mays L., Theoretical and Applied Genetics, 78 (2), S. 298-304, ist es bekannt, dass ein signifikant erhöhter Selektionsgewinn erzielt werden kann, wenn die Selektion der Samenkörner auf Basis von Einzelkörnern vorgenommen wird.

In Kotyk, J.J., Pagel, M.D., Deppermann, K.L., Colletti, R.F., Hoffman, N.G., Yannakakis, E.J., Ackerman, J.J.H. (2005), High-throughput determination of oil content in corn kernels using nuclear magnetic resonance imaging, Journal of the American Oil Chemists' Society, 82(12), S. 855-862, werden verschiedene Messverfahren zur Untersuchung der Eigenschaften von einzelnen Samenkörnern vorgestellt, darunter Lösungsmittel-Extrahierung, mikrowellenunterstützte Extrahierung und SOXTHERM-Extrahierung. Jedoch sind die darin dargestellten Verfahren zeit- und arbeitsaufwändig, wobei darüber hinaus häufig Chemikalien eingesetzt werden, welche die Samenkörner oder Bestandteile davon zerstören können. Diese Verfahren scheiden daher insbesondere dann aus, wenn die untersuchten Einzelkörner für eine weitere Erforschung und Züchtung verwendet werden sollen. Darüber hinaus erfordern diese Verfahren häufig eine Masse für die Proben, welche regelmäßig die Masse der zur Verfügung stehenden Einzelkörner überschreitet.

Daher werden bevorzugt zerstörungsfreie Untersuchungsmethoden zur Untersuchung der Eigenschaften von Samenkörnern eingesetzt. In Blanco, M., und Villarroya, I. (2002), NIR spectroscopy: a rapid-response analytical tool, Trends in Analytical Chemistry, 21(4), S. 240-250, wird hierzu der Einsatz von Nahinfrarot-Spektroskopie (NIRS) beschrieben, um Eigenschaften einer Vielzahl von ganzen oder gemahlenen Samenkörnern zu ermitteln, insbesondere deren Feuchtigkeitsgehalt oder Gehalt an Kohlenwasserstoffen, Proteinen oder Öl. Baye, T.M., Pearson, T.C., und Settles, A.M. (2006), Development of a calibration to predict maize seed composition using single kernel near infrared spectroscopy, Journal of Cereal Science, 43 (2), S. 236-243, und Niewitetzki, O., Tillmann, P., Becker, H. C., und Möllers, C. (2010), A new near-infrared reflectance spectroscopy method for high-throughput analysis of oleic acid and linolenic acid content of single seeds in oilseed rape (Brassica napus L.), Journal of Agricultural and Food Chemistry, 58 (1), S. 94-100, haben herausgefunden, dass NIRS-Untersuchungen an Einzelkörnern deutliche höhere Standard-Messfehler im Vergleich zu anderen Untersuchungsverfahren liefern und sich daher nur für Reihenuntersuchungen an Proben mit hoher Varianz des Ölgehalts eignen.

Daher dienen bevorzugt Verfahren der kernmagnetischen Resonanz (NMR-Verfahren) als schnelle, zerstörungsfreie und präzise Untersuchungsmethode zur Bestimmung von Eigenschaften einzelner Samenkörner. Beispielsweise sind NMR-Verfahren zur Ermittlung des Öl- und Wassergehalts in Einzelsamen verschiedener Getreidearten als StandardMethode anerkannt; siehe z.B. *Determination of oil content (Reference method),* ISO 659:2009). Darüber hinaus ist ein Einsatz von NMR-Verfahren zur Untersuchung des Wasser-, Kohlenwasserstoff- oder Proteingehalts in einzelnen Samenkörnern bekannt.

Die schnelle und effiziente Bestimmung der Eigenschaften einer großen Anzahl an Samenkörnern gilt jedoch nach wie vor als Herausforderung. Rolletschek, H., Fuchs, J., Friedel, S., Börner, A., Todt, H., Jakob, P. M., und Borisjuk, L. (2015), A novel noninvasive procedure for high-throughput screening of major seed traits, Plant Biotechnology Journal, 13 (2), S. 188-99, beschreiben eine an eine NMR-Messeinrichtung gekoppelte, automatische Probenbereitstellungsvorrichtung, mit der sich ein täglicher Durchsatz von bis zu 1400 Proben erzielen lässt. Allerdings löst diese Einrichtung weder das Problem der Vereinzelung der Samenkörner noch die Aufgabe der Selektion und/oder Sortierung von gewünschten Samenkörnern aus einer großen Anzahl an Samenkörnen. Dies trifft auch auf eine weitere in Kotyk et al, s.o., vorgestellte Vorrichtung zur Bestimmung des Ölgehalts in Maiskörnern mittels bildgebenden NMR-Verfahren (NMR-Imaging; MRI-Verfahren) zu, in welcher der für die Bereitstellung der Proben erforderliche Zeitaufwand die für die eigentliche Messung nötige Zeitdauer wesentlich überschreitet.

Die US 2014/0266196 A1 offenbart eine weitere NMR-Messeinrichtung für Saatgutkörner, welche mittels eines umlaufenden Förderbandes transportiert werden. Nachteilig hieran sind jedoch die niedrige Messgenauigkeit aufgrund der ungenauen Positionierung der Saatkörner in der Messeinrichtung sowie die Beschränkung auf Niedrigfeld-NMR.

Die DE 601 29 158 T2 offenbart Verfahren und Vorrichtungen zur zerstörungsfreien Analyse von Samen zur Bestimmung einer Eigenschaft innerhalb einer Probe mittels MRI-Imaging über eine Vielzahl von Probenstücken, um die durch MRI-Imaging erhaltenen Informationen zur Auswahl von Einzelkörnern zu verwenden. Zur Bereitstellung der Proben werden einzelne Platten mit einer Vielzahl von Vertiefungen (Wells), z.B. von 24, 48, 96 oder 960 Wells, mit Einzelkörnern beladen. Hieran anschließend werden die Platten in Schichten gestapelt, z.B. 5, 8, 12 oder mehr Platten übereinander, um auf diese Weise einen Probenwürfel zu erzeugen, dessen Außenmasse so ausgestaltet sind, dass er in eine Hochfrequenzspule der NMR-Messeinrichtung passt. Als Beispiele werden Probenwürfel mit Abmessungen von 15 cm x 20 cm x 12 cm zur Aufnahme von maximal 480 Samen bzw. mit Abmessungen von 30 cm x 35 cm x 30 cm zur Aufnahme von maximal 3456 Samen beschrieben. Je nach Stärke des Magnetfelds des NMR-Magneten und der angestrebten Auflösung werden einige Minuten bis einige Stunden zur Aufnahme der MRI-Bilder benötigt. Nachteilig hieran ist, dass die Untersuchungen der Saatgutkörner nur im Batch-Betrieb vorgenommen werden können. Da die Einzelkörner innerhalb der Platten nebeneinander und innerhalb der Schichten übereinander angeordnet sind, erfordert ein hoher Durchsatz an Samenkörnern zudem eine aufwändige NMR-Messeinrichtung mit einem großen Probenraum innerhalb der Hochfrequenzspule sowie ein möglichst starkes und homogenes Magnetfeld. Darüber hinaus bleiben die Aufgabe einer Vereinzelung der Saatgutkörner und eine Beschickung der Platten hierbei ungelöst.

Die DE 603 18 032 T2 offenbart ein automatisiertes System zum Aufnehmen, Wiegen und Sortieren von teilchenförmigem Material, insbesondere von Samenkörnern. Hierbei fallen die Samenkörner direkt auf eine Wiegeplattform und werden nach erfolgtem Wiegen von der Wiegeplattform durch ein Gebläse entfernt.

Die Aufgabe der vorliegenden Erfindung besteht daher darin, die aus dem Stand der Technik bekannten Nachteile und Einschränkungen von Systemen und Verfahren zur Untersuchung und darauf basierten Sortierung einer Vielzahl von mittels der Untersuchung klassifizierten Saatgutkörnern zumindest teilweise zu überwinden. Insbesondere sollen ein derartiges System und zugehörige Verfahren vorgeschlagen werden, welche eine Hochdurchsatz-Sortierung von mindestens 300, bevorzugt von mindestens 600, besonders bevorzugt von mindestens 1000 Einzelkörnern pro Stunde auf eine möglichst vollautomatische Weise ermöglichen. Hierzu soll insbesondere eine Probenvorrichtung vorgeschlagen werden, welche zur Einführung eines vereinzelten Saatgutkornes in eine Messeinrichtung zur Untersuchung eines Einzelkorns eingerichtet ist. Die Sortierung der Samenkörner soll hierbei zu einer Bereitstellung von mindestens zwei Fraktion an Einzelkörnern mit unterschiedlichen Eigenschaften führen und/oder die Bereitstellung von einzeln klassifizierten und individuell leicht zugänglichen Saatkörnern ermöglichen.

### Offenbarung der Erfindung

Diese Aufgabe wird gelöst durch eine Probenvorrichtung zur Einführung eines vereinzelten Saatgutkornes in eine Messeinrichtung, durch ein System und ein Verfahren zum Sortieren einer Vielzahl von Saatgutkörnern sowie durch die Verwendung des Systems mit den Merkmalen der unabhängigen Patentansprüche. Vorteilhafte Ausgestaltungen finden sich in den abhängigen Patentansprüchen.

In einem ersten Aspekt betrifft die vorliegende Erfindung eine Probenvorrichtung zur Einführung eines vereinzelten Saatgutkornes in eine Messeinrichtung.

Unter dem Begriff der "Probenvorrichtung" wird hierbei eine Einrichtung verstanden, mit welcher eine Probe vorzugsweise derart in einen Probenraum der Messeinrichtung eingebracht werden kann, dass hierdurch an der Probe eine Untersuchung auf mindestens eine gewünschte Eigenschaft der Probe ausgeführt werden kann. Als der "Probenraum" wird hierbei wie üblich derjenige Bereich der Messeinrichtung bezeichnet, welcher zur Aufnahme der Probe eingerichtet ist. Besonders vorteilhaft ist die Probenvorrichtung derart ausgestaltet, dass die Untersuchung der Probe innerhalb des Probenraums zu einem möglichst reproduzierbaren Ergebnis mit möglichst hohem Signal-Rausch-Verhältnis führt.

Der Begriff der "Messeinrichtung" betrifft im Rahmen der vorliegenden Erfindung grundsätzlich jegliche Vorrichtung, welche für die vorgesehene Untersuchung geeignet ist und welche einen entsprechend ausgestalteten Probenraum zur Aufnahme der Probenvorrichtung aufweist. Messeinrichtungen, welche zur Durchführung von Verfahren der kernmagnetischen Resonanz (NMR-Verfahren) und/oder bildgebenden NMR-Verfahren (NMR-Imaging; MRI-Verfahren) sind hierbei besonders bevorzugt. Allerdings hier ist auch ein Einsatz von anderen Messeinrichtungen möglich, insbesondere von optischen Messeinrichtungen, welche zur Durchführung von spektroskopischen Verfahren eingerichtet sind.

Weitere Messeinrichtungen, die ebenfalls über einen Probenraum zur Aufnahme einer angepassten Probenvorrichtung verfügen, sind jedoch denkbar.

Handelt es sich bei der Messeinrichtung beispielsweise um eine NMR-Messeinrichtung, welche zur Durchführung von NMR-Verfahren und/oder von MRI-Verfahren eingerichtet ist, stellt die Probenvorrichtung vorzugsweise die Probe derart bereit, dass sich die Probe in dem Probenraum innerhalb einer Hochfrequenzspule der NMR-Messeinrichtung in einem möglichst homogenen Magnetfeld befindet. Handelt es sich dagegen bei der Messeinrichtung zum Beispiel um eine optische Messeinrichtung, welche zur Durchführung von spektroskopischen Verfahren in einem optischen oder einem hieran angrenzenden Spektralbereich, vorzugsweise im Infrarot (NIS), insbesondere im Nahinfrarot (NIRS), eingerichtet ist, kann die Probenvorrichtung die Probe vorzugsweise derart bereitstellen, dass sich die Probe im Probenraum möglichst innerhalb eines Lichtstrahls oder innerhalb einer Lichtscheibe einer optischen Strahlung befindet.

Die vorliegende Erfindung betrifft die Untersuchung von Proben, welche einzelne oder vereinzelte Saatgutkörner oder eine unten näher beschriebene Gruppe von wenigen vereinzelten Saatgutkörnern umfassen. Das "Saatgutkorn", welches auch als "Samenkorn", als "Einzelkorn" oder auch als "Samen" bezeichnet werden kann und gemäß der botanischen Begriffsterminologie sowohl Samen als auch Früchte umfasst, kann ein beliebiges Samenkorn sein, an welchem mittels der Messeinrichtung eine Eigenschaft ermittelt werden soll. In einer bevorzugten Ausführungsform ist das Saatgutkorn ausgewählt aus der Gruppe der Arten, die im Artenverzeichnis zum Saatgutverkehrsgesetz (SaatG) der Bundesrepublik Deutschland (Ausfertigungsdatum 31.8.1985, letzte Änderung von 31.8.2015) aufgeführt sind, bevorzugt alle landwirtschaftlichen Arten, Gemüsearten, ferner alle dort nicht aufgeführten heimischen und exotischen Getreide-,Öl-, Faser-, Heil-, Würz-, Duft-, und Zierpflanzenarten und Pflanzen zur Herstellung von Kosmetika, sowie Wildpflanzen- und Forstpflanzenarten, bevorzugt solche, die in der Liste der Baumarten in der Anlage zum Forstvermehrungsgesetz (FoVG) der Bundesrepublik Deutschland (Ausfertigungsdatum 22.5.2002, letzte Änderung von 31.8.2015) aufgeführt sind. In einer besonders bevorzugten Ausführungsform ist das Saatgutkorn ein Samen von Mais oder Jatropha.

Darüber hinaus umfasst der Begriff des "Saatgutkorns" auch künstlich hergestellte Objekte, insbesondere technologisches Saatgut und pillenförmige Objekte, welche in Form und Größe natürlich vorkommenden Saatgutkörnern ähneln oder gleichen.

Der Begriff des "vereinzelten Saatgutkornes" bezieht sich hierbei auf ein einzelnes Saatgutkorn, welches aus einer Vielzahl von Saatgutkörnern isoliert wurde, um durch die anschließende Bestimmung mindestens einer seiner Eigenschaften klassifiziert und/oder individualisiert zu werden. Eine Bereitstellung des vereinzelten Saatgutkornes kann vorzugsweise mittels mindestens einer unten näher beschriebenen Vereinzelungsvorrichtung, welche zur Vereinzelung von Saatgutkörnern aus einer Vielzahl von bereitgestellten Saatgutkörnern eingerichtet ist, erfolgen. Andere Möglichkeiten sind jedoch denkbar.

Die vereinzelten Saatgutkörner werden erfindungsgemäß einer Messung und darauf basierend bevorzugt einer Klassifikation unterzogen, wofür eine geeignete Messeinrichtung eingesetzt wird. Der Begriff der "Klassifikation" bezieht sich im Rahmen der vorliegenden Erfindung auf die Zuordnung mindestens eines, mittels der Messeinrichtung bestimmten Wertes oder Wertebereiches einer ausgewählten Eigenschaft zu einer Klasse, zu welcher ein vereinzeltes Saatgutkorn oder, alternativ, eine Gruppe von mindestens zwei Saatgutkörnern gehört, wobei die Saatgutkörner in der Gruppe jeweils als vereinzeltes Saatgutkorn oder als Fraktion an Einzelkörnern mit denselben Eigenschaften vorliegen können. Zur Zuordnung des Wertes oder des Wertebereiches zu einer bestimmten Klasse kann hierbei eine Schwelle vorgegeben werden, welche überschritten und/oder unterschritten werden muss, damit die Zuordnung erfolgen kann. Die Klassifikation der Samenkörner kann somit zu einer Bereitstellung von mindestens zwei Fraktionen an Einzelkörnern mit unterschiedlichen Eigenschaften führen. Alternativ oder zusätzlich hierdurch kann die Bereitstellung von einzeln klassifizierten und individuell zugänglichen Saatkörnern ermöglicht werden.

Die hier vorgeschlagene Probenvorrichtung umfasst hierbei mindestens
- ein äußeres Röhrchen zur Aufnahme der Probenvorrichtung in die Messeinrichtung, wobei innerhalb eines Volumens des äußeren Röhrchens ein Probenraum der Messeinrichtung vorgesehen ist, wobei das äußere Röhrchen über einen geschlossenen Boden verfügt;
- ein inneres Röhrchen zur Aufnahme eines vereinzelten Saatgutkornes, wobei das innere Röhrchen in das äußere Röhrchen eingeführt ist und eine Öffnung an seiner Unterseite aufweist, wodurch das vereinzelte Saatgutkorn in das Volumen des äußeren Röhrchens einführbar ist; und
- einen Zwischenraum zwischen dem äußeren Röhrchen und dem inneren Röhrchen, wobei der Zwischenraum derart eingerichtet ist, dass das vereinzelte Saatgutkorn auf pneumatischem Wege aus dem äußeren Röhrchen durch das innere Röhrchen hindurch in eine Aufnahmeeinrichtung für ein klassifiziertes Saatgutkorn austragbar ist.

Erfindungsgemäß verfügt die Probenvorrichtung somit über ein äußeres Röhrchen, ein in das äußere Röhrchen eingebrachtes inneres Röhrchen und einen auf diese Weise zwischen dem äußeren Röhrchen und dem inneren Röhrchen ausgebildeten Zwischenraum. Der Begriff des "Röhrchens" bezeichnet hierbei einen länglichen Hohlkörper, welcher über eine Länge entlang der Längsachse des Röhrchens und über eine Querschnittsfläche senkrecht zur Längsachse verfügt, wobei die Länge des Röhrchens die Wurzel aus dessen Querschnittsfläche übertrifft. Der Querschnitt des Röhrchens kann hierbei grundsätzlich eine beliebige Form annehmen, wobei insbesondere runde Formen bevorzugt sind. Im Falle eines runden Querschnitts weist das Röhrchen somit einen inneren Durchmesser und einen äußeren Durchmesser auf, deren Differenz eine Wandstärke des Röhrchens angibt. Für einen Einsatz in optischen Verfahren kann das Röhrchen bevorzugt als transparentes Röhrchen ausgebildet sein und insbesondere aus Glas, Quarz oder einem transparenten Kunststoff bestehen. Für einen Einsatz in NMR-Verfahren ist es vorteilhaft, wenn das Röhrchen ein für Radiowellen möglichst gut durchlässiges Material aufweist.

Das äußere Röhrchen ist hierbei derart ausgestaltet, dass es zur Aufnahme der Probenvorrichtung in die Messeinrichtung eingerichtet ist. Die Messeinrichtung ist bevorzugt zur Aufnahme der Probenvorrichtung eingerichtet und verfügt vorzugsweise über einen Probenraum, welcher derart in der Messvorrichtung angeordnet ist, dass sich zumindest ein Volumen innerhalb des äußeren Röhrchens nach Aufnahme der Probenvorrichtung in die Messeinrichtung innerhalb des Probenraums der Messeinrichtung befindet. Auf diese Weise kann sichergestellt werden, dass eine sich in diesem Volumen des äußeren Röhrchens befindliche Probe gleichzeitig in dem Probenraum der Messeinrichtung vorliegt. Wie bereits erwähnt, kann die Probe erfindungsgemäß genau ein vereinzeltes Saatgutkorn oder, alternativ, eine Gruppe von wenigen vereinzelten Saatgutkörnern umfassen. Unter der Gruppe von wenigen vereinzelten Saatgutkörnern wird hierbei eine Anzahl von mindestens zwei vereinzelten Saatgutkörnern verstanden, wobei eine im Einzelfall ausgewählte Anzahl an Saatgutkörnern insbesondere von Größe und Form der betreffenden Saatgutkörner sowie des zur Verfügung stehenden Volumens im inneren Röhrchen abhängt. Auf diese Weise kann sich der Durchsatz an Saatgutkörnern durch die Probenvorrichtung und das zugehörige System weiter erhöhen lassen.

Eine Probe, welche in den Probenraum der Messeinrichtung gelangen soll, ist erfindungsgemäß somit über das innere Röhrchen in das des äußeren Röhrchens einführbar, welches sich gleichzeitig in dem Probenraum der Messeinrichtung befindet. Um eine möglichst genaue Positionierung des vereinzelten Saatgutkorns in dem Probenraum zu gewährleisten, ist das innere Röhrchen in das äußere Röhrchen eingeführt und an seiner Unterseite offen. Dadurch kann das vereinzelte Saatgutkorn insbesondere durch seine Schwerkraft aus dem unten offenen inneren Röhrchen in das unten geschlossene äußere Röhrchen, welches einen geschlossenen Boden aufweist, gelangen.

Wie bereits erwähnt, verfügen hierbei sowohl das äußere Röhrchen als auch das innere Röhrchen vorzugsweise über eine runde Querschnittsfläche, wobei das innere Röhrchen zentriert in das äußere Röhrchen eingebracht ist, wodurch sich ein ringförmiger Zwischenraum zwischen dem äußeren Röhrchen und dem inneren Röhrchen ausbilden kann. Ist der Probenraum nun ebenfalls zentriert oberhalb des Bodens des äußeren Röhrchens angeordnet und befindet sich das offene Ende des inneren Röhrchens möglichst innerhalb des Probenraums, so kann sich das vereinzelte Saatgutkorn direkt in den zentrierten Probenraum einführen lassen. In einer besonderen Ausgestaltung kann hierbei das innere Röhrchen entlang seiner Längsachse verschiebbar gegen die Längsachse des äußeren Röhrchens gelagert sein. Auf diese Weise kann diese Ausgestaltung sicherstellen, dass die Probe weitgehend unabhängig von Größe und Form möglichst exakt in dasjenige Volumen der Probenvorrichtung gelangt, welches gleichzeitig den Probenraum der Messeinrichtung darstellt.

Die Probenvorrichtung ist erfindungsgemäß weiterhin derart ausgestaltet, dass die vereinzelte und mittels der Messeinrichtung zumindest teilweise klassifizierte Probe, insbesondere nach einem Messvorgang, wieder aus dem Volumen der Probenvorrichtung entfernt werden kann, um in diesem Volumen wieder Platz für eine weitere Probe zu schaffen. Hierzu ist der zwischen dem äußeren Röhrchen und dem inneren Röhrchen angeordnete Zwischenraum vorgesehen, welcher für den Fall, dass sowohl das äußere Röhrchen als auch das in das äußere Röhrchen eingefügte innere Röhrchen eine runde Querschnittsfläche aufweisen, ringförmig ausgestaltet sein kann. Der Zwischenraum kann hierbei vorzugsweise zur Zuführung von Druckluft in das äußere Röhrchen eingerichtet sein, so dass das vereinzelte Saatgutkorn durch eine Beaufschlagung mit Druckluft somit aus dem äußeren Röhrchen durch das innere Röhrchen hindurch ausgetragen werden kann, um auf diese Weise durch einen Ausblasvorgang aus der Probenvorrichtung in eine Aufnahmeeinrichtung für ein klassifiziertes Saatgutkorn zu gelangen. Hierzu kann es besonders vorteilhaft sein, wenn das innere Röhrchen derart in das äußere Röhrchen eingebracht ist, dass das innere Röhrchen möglichst nur einen Spalt, dessen Breite etwa der Breite des Zwischenraums entsprechen kann, oberhalb des geschlossenen Bodens des äußeren Röhrchens endet. Auf diese Weise kann sich am geschlossenen Boden des äußeren Röhrchens eine Wirbelströmung ausbilden, welche sich vorteilhaft auf die gewünschte Austragung des vereinzelten Saatgutkorns aus dem äußeren Röhrchen auswirken kann.

In einer alternativen Ausgestaltung, kann das sich in dem äußeren Röhrchen befindliche klassifizierte Saatgutkorn mittels Absaugen durch das innere Röhrchen hindurch ausgetragen werden, wobei hier der Zwischenraum und der Spalt insbesondere zur Ermöglichung eines Druckausgleichs eingesetzt werden können.

Um weiterhin sicherzustellen, dass die klassifizierte Probe auch tatsächlich der Aufnahmeeinrichtung zugeleitet wird und nicht etwa fälschlicherweise wieder zu einem vorherigen Modul, insbesondere der Vereinzelungsvorrichtung oder der Wiegeeinrichtung, zurückgelangen kann, kann die Probenvorrichtung in einer besonders bevorzugten Ausgestaltung über eine Einstellvorrichtung verfügen, welche zu einer Steuerung einer Öffnung zwischen einem Eingang für das vereinzelte Saatgutkorn und einem Ausgang zur Aufnahmeeinrichtung für das klassifizierte Saatgutkorn eingerichtet ist. Zur Steuerung der Einstellvorrichtung kann ein Luftschleier vorgesehen sein, welcher insbesondere während des Ausblasvorgangs des Saatgutkorns verhindern kann, dass das klassifizierte Saatgutkorn wieder zu dem vorherigen Modul zugeleitet würde. Der Begriff des "Luftschleiers" bezeichnet hierbei eine Vorrichtung, welche mittels gerichteter Luftmassen eine Barriere aus strömender Luft bereitstellt, welche räumliche Bereiche so voneinander trennen kann, dass auf diese Weise ein Austausch zwischen den getrennten Bereichen verhindert wird.

Eine Kombination aus pneumatischem Transport des klassifizierten Saatgutkornes und eine Lenkung dessen weiteren Weges mittels der einstellbaren Einrichtung kann somit sicherstellen, dass das klassifizierte Saatgutkorn nach dem Messvorgang in die Aufnahmeeinrichtung gelangt und hierbei in der Probenvorrichtung Platz für ein nachfolgendes vereinzeltes Saatgutkorn bereitstellt. Durch eine geeignete Steuerung des Ausblasvorgangs und der einstellbaren Einrichtung kann hier in bevorzugter Weise ein Takt eingerichtet werden, mit welchem die vereinzelten Saatgutkörner nacheinander in die Probenvorrichtung eingeführt und ausgeleitet werden. Auf diese Weise können nacheinander mindestens 300, bevorzugt mindestens 600, besonders bevorzugt mindestens 1000 Einzelkörner pro Stunde jeweils einem Messvorgang zugeführt werden.

In einer bevorzugten Ausgestaltung weist die Probenvorrichtung eine Anschlussvorrichtung auf, welche zur Aufnahme des äußeren Röhrchens, des inneren Röhrchens sowie eines Einlasses und eines Auslasses für einen Luftaustausch zum pneumatischen Transport des Saatgutkornes, insbesondere zur Zuführung von Druckluft oder Absaugluft und/ oder für einen Druckausgleich in den beiden Röhrchen, eingerichtet ist. Hierbei kann die Anschlussvorrichtung vorzugsweise derart ausgestaltet sein, dass sie über Aufnahmen für das äußere Röhrchen und das innere Röhrchen verfügt, welche derart ausgestaltet sind, dass sich zwischen dem äußeren Röhrchen und dem inneren Röhrchen ein ringförmiger Zwischenraum auszubilden vermag, wobei die Anschlussvorrichtung dazu eingerichtet sein kann, dass sich die beiden Röhrchen in Bezug auf ihre Längsachsen gegeneinander verstellen lassen. Die Anschlussvorrichtung kann insbesondere dazu dienen, um eine form- und/oder kraftschlüssige Verbindung zwischen der Probenvorrichtung und einer zur Einbringung der Probenvorrichtung in die Messeinrichtung vorgesehenen Aufnahme der Messeinrichtung herzustellen. Auf diese Weise kann die Probenvorrichtung einschließlich des Eingangs für das vereinzelte Saatgutkorn und des Ausgangs für das klassifizierte Saatgutkorn druckfest abgeschlossen werden, um so eine volle Funktionalität der Probenvorrichtung im Hinblick auf eine aufeinanderfolgende Einführung und Ausleitung der Saatgutkörner zu ermöglichen.

Für weitere Einzelheiten in Bezug auf die Probenvorrichtung wird auf die nachfolgende Beschreibung der Ausführungsbeispiele verwiesen.

In einem weiteren Aspekt betrifft die vorliegende Erfindung ein System zum Sortieren einer Vielzahl von Saatgutkörnern. Das System umfasst
- mindestens eine Vereinzelungsvorrichtung zur Vereinzelung von Saatgutkörnern aus einer Vielzahl von bereitgestellten Saatgutkörnern;
- mindestens eine Probenvorrichtung zur Einführung des vereinzelten Saatgutkornes in eine Messeinrichtung, welche zur Klassifikation des vereinzelten Saatgutkornes einsetzbar ist;
- mindestens eine Einfülleinrichtung zur Einbringung des klassifizierten Saatgutkornes in eine Aufnahmeeinrichtung; und
- mindestens eine Transporteinrichtung zum zumindest teilweise pneumatischen Transport des Saatgutkornes aus einem Vorrat in die Vereinzelungsvorrichtung, aus der Vereinzelungsvorrichtung in die Probenvorrichtung und aus der Probenvorrichtung in die Aufnahmeeinrichtung.

Unter dem Begriff des "Systems" wird hierbei eine in der Regel mehrteilige Vorrichtung verstanden, in welcher Module, welche die aufgeführten Einrichtungen umfassen und gegebenenfalls weitere Einrichtungen aufweisen können, in einer Wechselwirkung zueinander angeordnet sind. In einer besonders bevorzugten Ausgestaltung kann das System hierbei zusätzlich eine Wiegeeinrichtung als weiteres Modul aufweisen, welche zur Ermittlung eines Gewichts eines vereinzelten Saatgutkornes im Rahmen eines Wiegevorgangs eingerichtet ist. Auf diese Weise lässt sich das so ermittelte Gewicht des vereinzelten Saatgutkornes in Beziehung zu den weiteren, in der Messeinrichtung bestimmten Eigenschaften setzen.

Die Vereinzelungsvorrichtung dient hierbei zur Vornahme eines Vereinzelungsvorgangs, welcher hier in einer Vereinzelung der Saatgutkörner aus einer Vielzahl von Saatgutkörnern besteht, welche dem System aus einem hierzu bereitgestellten Vorrat zugeführt werden können. Insbesondere um eine möglichst lange, ungestörte Durchführung des hier vorgeschlagenen Sortierverfahrens zu ermöglichen, kann die Vereinzelungsvorrichtung zusätzlich mit einer Vibrationseinrichtung oder einem Rührwerk versehen werden, wodurch, wie experimentelle Untersuchungen gezeigt haben, eine Blockierung der Vereinzelungsvorrichtung, insbesondere durch eine Verstopfung mit Samenkörnern, und damit des gesamten Systems weitgehend vermieden werden kann.

Als Vereinzelungseinrichtung kann hierbei jede Einrichtung eingesetzt werden, welche für diesen Zweck eingerichtet ist. Bevorzugt kann jedoch die in Karayel, D., Barut, Z. B., und Özmerzi, A. (2004), Mathematical Modelling of Vacuum Pressure on a Precision Seeder, Biosystems Engineering, 87 (4), S. 437-444, beschriebene Vereinzelungsvorrichtung eingesetzt werden, welche bereits in pneumatischen Präzisionssämaschinen Verwendung findet. Diese Vereinzelungsvorrichtung umfasst einen Zuführtrichter, eine rotierende Vakuumplatte mit einem austauschbaren Trennkopf und eine gegen die Vakuumplatte gerichtete Profilplatte, welche einen Kanal für den Transport des Einzelkorns bereitstellt. Durch Bereitstellung eines Unterdrucks an einer zentralen Öffnung des Trennkopfs, deren Durchmesser vorzugsweise etwa ein Zehntel der Größe des Samenkorns betragen kann, kann das Saatgutkorn so lange am Trennkopf festgehalten werden, bis es freigegeben wird. Nach einer Vierteldrehung der Vereinzelungsvorrichtung kann das Samenkorn mittels eines Luftstoßes ausgestoßen werden, um vorzugsweise durch ein Ausstoßröhrchen in ein weiteres Modul des vorliegenden Systems zu gelangen.

In einer besonderen Ausgestaltung kann hierbei das Ausstoßröhrchen derart angeordnet sein, dass dadurch das Saatgutkorn dem oben beschriebenen Eingang für das vereinzelte Saatgutkorn in der Probenvorrichtung geführt werden kann. Vorzugsweise kann das Ausstoßröhrchen jedoch derart angeordnet sein, dass dadurch das Saatgutkorn zu einem Eingang der Wiegeeinrichtung geleitet wird, welche vorzugsweise unmittelbar nach der Vereinzelungsvorrichtung angeordnet sein kann, um so vor dem Messvorgang den Wiegevorgang auszuführen. Alternativ kann das Saatgutkorn auch zunächst der Probenvorrichtung zugeführt werden, bevor es dem Eingang der Wiegeeinrichtung zugeleitet wird, um so erst nach dem Messvorgang den Wiegevorgang vornehmen zu können. Weitere Möglichkeiten sind denkbar.

In einer bevorzugten Ausgestaltung kann das Saatgutkorn aus dem Ausstoßröhrchen der Vereinzelungseinrichtung mittels Schwerkraft auf die Wiegeeinrichtung geführt werden, wobei die Wiegeeinrichtung bevorzugt über eine Dämpfungseinrichtung verfügen kann, welche zur Verminderung des durch das Saatgutkorn auf die Wiegeeinrichtung ausgelösten Kraftstoßes eingerichtet ist. Ein Einsatz einer Dämpfungseinrichtung kann insbesondere dann vorteilhaft sein, wenn es sich bei der Wiegeeinrichtung um eine für den Fall der vorliegenden Erfindung besonders geeignete Präzisionswaage handelt, um eine Überladung durch ein auf die Waage fallendes Saatgutkorn und/oder durch eine Ausbildung eines Luftdrucks nach Entnahme des Saatgutkorns möglichst weitgehend zu vermeiden. Der Begriff der "Präzisionswaage" bezeichnet hierbei eine Wiegeeinrichtung, welche die in der Norm *Metrologische Aspekte der nichtselbsttätigen Waagen*, EN 45501:2015, deutsche Fassung DIN EN 45501:2016-03, festgelegten Spezifikationen für Präzisionswaagen, d.h. einer nichtselbsttätigen Waage der Genauigkeitsklasse II, erfüllt. Die Verwendung einer Präzisionswaage ist auch daher besonders vorteilhaft, da ein typisches Saatgutkorn ein sehr geringes Gewicht aufweist. Beispielsweise wiegt ein Maiskorn ca. 100 mg bis 500 mg, während ein Rapskorn deutlich leichter ist und ein Gewicht von etwa 1,5 mg bis 10 mg aufweist. Eine möglichst genaue Ermittlung des Gewichts des Saatgutkornes kann insbesondere dazu geeignet sein, um den Messfehler bei Bestimmung einer gewichtsbezogenen Eigenschaft des Saatgutkornes deutlich zu verringern.

In einer besonders bevorzugten Ausgestaltung kann das Saatgutkorn aus dem Ausstoßröhrchen der Vereinzelungseinrichtung, insbesondere mittels Schwerkraft, zunächst auf eine ebene Platte geführt werden. Die ebene Platte kann hierbei über mindestens zwei Öffnungen verfügen, wobei eine erste Öffnung für die Wiegeeinrichtung und eine weitere Öffnung für die Zuführung zum Eingang in die Probenvorrichtung vorgesehen sein können. Der Transport des vereinzelten Saatgutkornes auf der ebenen Platte kann hierbei bevorzugt über eine seitliche mechanische Bewegung des Samenkorns, etwa durch Schieben des Samenkorns, beispielsweise mit Hilfe eines Drehmagazins, über die Oberfläche der ebenen Platte erfolgen. Auf diese Weise lässt sich die oben beschriebene Überladung der Wiegeeinrichtung durch ein auf die Waage fallendes Saatgutkorn und/oder durch eine Entstehung von Luftdruck nach Entnahme des Saatgutkorns nahezu vollständig vermeiden.

Nach erfolgtem Wiegevorgang kann das Saatgutkorn nunmehr dem oben beschrieben Eingang für das vereinzelte Saatgutkorn in der Probenvorrichtung zugeleitet werden. Dies kann vorzugsweise dadurch erfolgen, dass das Ausstoßröhrchen aus der Vereinzelungsvorrichtung mit einem Drehmagazin mit vier vorzugsweise steuerbaren Haltepunkten verbunden sein kann, wobei ein Haltepunkt mit einer Wiegeposition zur Vornahme des Wiegevorgangs verbunden sein kann, für dessen Vornahme eine Drehung des Drehmagazins als Zeitintervall bereitgestellt werden kann. Nach erfolgtem Wiegevorgang kann zunächst eine weitere Vierteldrehung des Drehmagazins vorgenommen werden, bevor das Saatgutkorn tatsächlich dem Eingang für das vereinzelte Saatgutkorn in der Probenvorrichtung zugeleitet wird. Auf diese Weise kann somit ein doppeltes Zeitintervall für den Messvorgang in der Messeinrichtung zur Verfügung stehen. Für diesen Zweck kann die oben beschriebene ebene Platte mindestens zwei eben auf der Platte angeordnete Parkpositionen aufweisen, in welchen das Saatgutkorn während eines Parkvorgangs verbleiben kann.

Wie bereits oben beschrieben, kann die Zuführung des vereinzelten Saatgutkornes in den Eingang für das vereinzelte Saatgutkorn in der Probenvorrichtung mit oder ohne zuvor durchgeführtem Wiegevorgang vorzugsweise durch Schwerkraft erfolgen, indem das vereinzelte Saatgutkorn, welches in den Probenraum der Messeinrichtung gelangen soll, über das innere Röhrchen in das äußere Röhrchen der Messeinrichtung einführbar ist, welches sich gleichzeitig in dem Probenraum der Messeinrichtung befindet. Als die Probenvorrichtung zur Einführung des vereinzelten Saatgutkornes in eine Messeinrichtung, welche zur Klassifikation des vereinzelten Saatgutkornes einsetzbar ist, dient hierbei vorzugsweise die in der vorliegenden Anmeldung näher beschriebene Probenvorrichtung.

Weiterhin umfasst das System mindestens eine Transporteinrichtung, welche zum zumindest teilweise pneumatischen Transport des Saatgutkornes aus einem Vorrat in die Vereinzelungsvorrichtung, aus der Vereinzelungsvorrichtung in die Probenvorrichtung und aus der Probenvorrichtung in die Aufnahmeeinrichtung eingerichtet ist. Vorzugsweise kann die Transporteinrichtung auch für weitere Transportvorgänge ausgestaltet sein, insbesondere zum Transport des Saatgutkornes in die Wiegeeinrichtung und aus der Wiegeeinrichtung heraus. Unter dem Begriff der "Transporteinrichtung" wird hierbei eine beliebige, vorzugsweise mehrteilige Vorrichtung verstanden, welche über Module verfügt, die jeweils zum Transport des Saatgutkornes, vorzugsweise des in der Vereinzelungsvorrichtung vereinzelten Saatgutkornes, von einem ersten Ort an einen zweiten Ort eingerichtet sind. Vorzugsweise kann hierzu die Transporteinrichtung Vorrichtungen aufweisen, welche den Einsatz von Druckluft und/oder eines Absaugvorgangs zur Vornahme mindestens eines Teiles der Transportvorgänge auf pneumatischem Wege ermöglichen. Ein weiterer Teil der Transportvorgänge kann hierbei mittels anderer Möglichkeiten, insbesondere mittels des Einsatzes der Schwerkraft erfolgen. Denkbar ist auch, dass ein ausgewählter Teil der Transportvorgänge mittels eines Einsatzes eines Industrieroboters vorgenommen werden kann; allerdings haben diesbezügliche experimentelle Versuche gezeigt, dass übliche Industrieroboter die Aufgabe aufgrund der nicht identischen Größe von tatsächlich vorkommenden Saatgutkörnern nur unzureichend und/oder mit erheblichem Aufwand zu erfüllen vermögen. Mit der hier beschriebenen, bevorzugten Auswahl einer Kombination aus mechanisch und pneumatisch gesteuerten Transportvorgängen kann dagegen die eingangs gestellte Aufgabe, mindestens 300, bevorzugt mindestens 600, besonders bevorzugt mindestens 1000 Einzelkörner pro Stunde jeweils einem Messvorgang zuzuführen, auf zuverlässige Weise gelöst werden, bei welcher natürliche Variationen der Größe und des Gewichts der Saatgutkörner unerheblich bleibt.

Das vorliegende System verfügt weiterhin über mindestens eine Einfülleinrichtung zur Einbringung des klassifizierten Saatgutkornes in die Aufnahmeeinrichtung, welche zur Aufnahme des insbesondere in der Messeinrichtung und/oder der Wiegeeinrichtung klassifizierten Saatgutkornes eingerichtet ist. Zur Vornahme eines damit in Verbindung stehenden Sortiervorgangs kann sich grundsätzlich jede Aufnahmeeinrichtung eignen, die zumindest ein, vorzugsweise mehrere klassifizierte Saatgutkörner aufnehmen kann. Eine Zuführung des klassifizierten Saatgutkornes in die Aufnahmeeinrichtung kann hierbei vorzugsweise mit einem flexiblen Röhrchen erfolgen, welches zur Aufnahme des Saatgutkornes aus dem oben beschriebenen Ausgang der Probenvorrichtung eingerichtet ist, wobei die Einfülleinrichtung vorzugsweise mit einem Führungskopf zur Verteilung und Einbringung des Saatgutkornes in einen vorgesehenen Teil der Aufnahmeeinrichtung ausgestattet sein kann.

In einer ersten bevorzugten Ausgestaltung kann die Aufnahmeeinrichtung hierfür mindestens zwei zur Aufnahme des mindestens einen klassifizierten Saatgutkornes eingerichtete Behälter aufweisen. Bevorzugt verfügt die Aufnahmeeinrichtung jedoch über mindestens vier, vorzugsweise sechs, besonders bevorzugt zehn Behälter, welche jeweils unterschiedliche Fraktionen an Saatgutkörnern aufnehmen können. Insbesondere bei Einsatz eines Industrieroboters kann sich so eine zweidimensionale Ablage ausbilden lassen, in welcher die Zahl der Behälter letztlich nur durch den zur Verfügung stehenden Raum begrenzt ist. Die Behälter können beispielsweise aus Plastik, Papier oder Pape ausgestaltet sein. Vorzugsweise sind die Behälter nebeneinander angeordnet, wodurch das klassifizierte Saatgutkorn insbesondere mittels einer geeignet dimensionierten Schwenkeinrichtung in einen ausgewählten Behälter einbringbar sein kann. Damit unterscheidet sich die vorliegende Aufnahmeeinrichtung somit auch von der in Rolletschek et al., s.o., vorgestellten Aufnahmeeinrichtung, welche eine manuelle Beladung der Behälter erfordert. Andere Ausgestaltungen sind jedoch denkbar.

In einer weiteren, besonders bevorzugten Ausgestaltung kann die Aufnahmeeinrichtung hierfür eine Ablage zur Aufnahme der klassifizierten Saatgutkörner aufweisen. Unter dem Begriff der "Ablage" wird hierbei eine Platte verstanden, welche über eine Anzahl an Vertiefungen, die auch als "Wells" bezeichnet werden können, z.B. 48, 60, 96, 240, 300, 480, 600 oder 960 Wells, zur Aufnahme eines klassifizierten Saatgutkornes, insbesondere jeweils genau eines klassifizierten Saatgutkornes, oder, alternativ, einer oben beschriebenen Gruppe von wenigen klassifizierten Saatgutkörnern, in genau eine Vertiefung verfügt. Die Vertiefungen können hierbei bevorzugt in Form einer Matrix über die Platte verteilt sein. Als Material für die Platte kann vorzugsweise ein festes, transparentes Material, insbesondere Glas, Quarz oder ein transparenter Kunststoff dienen. Die technische Ausgestaltung kann hierbei sehr flexibel durchgeführt werden. Die Platte kann hierbei Außenmaße von 5 x 10 cm² bis 100 x 200 cm², bevorzugt von 10 x 20 cm² bis 50 x 100 cm², und eine Dicke von 0,5 cm bis 5 cm, bevorzugt von 1 cm bis 2,5 cm, annehmen.

Zur Vornahme des Sortiervorgangs kann das klassifizierte Saatgutkorn insbesondere mittels einer pneumatisch bedienbaren Einfülleinrichtung in eine ausgewählte Vertiefung einbringbar sein. Andere Ausgestaltungen sind jedoch denkbar, insbesondere eine Ablage, welche über in Form einer Matrix über die Ablage verteilte Behälter zur Aufnahme jeweils einer bestimmten Fraktion von klassifizierten Saatgutkörnern aufweist.

Zur Entnahme eines bestimmten ausgewählten individualisierten klassifizierten Saatgutkorns aus der Ablage sind mehrere Möglichkeiten denkbar. Trotz der oben beschriebenen Nachteile kann im Einzelfall der Einsatz eines Industrieroboters möglich sein. Bevorzugt kann jedoch eine pneumatische Austragung des ausgewählten Saatgutkornes zum Beispiel in ein Proberöhrchen durch Beaufschlagung des Einzelkorns mittels Druckluft erfolgen. Hierzu kann insbesondere am Boden jeder Vertiefung der Ablage eine Öffnung, deren Querschnittsfläche die Maße des sich darin befindlichen Saatgutkorns vorzugsweise deutlich unterschreitet, vorgesehen sein, durch welche die zur Entnahme des ausgewählten Saatgutkornes erforderliche Druckluft in die jeweilige Vertiefung eingebracht werden kann. Alternativ kann auch ein Absaugen des Saatgutkorns aus der jeweiligen Vertiefung erfolgen. Insbesondere kann hierzu eine bewegliche Plattform vorgesehen sein, mittels welcher die plattenförmige Ablage innerhalb einer Ebene oberhalb oder unterhalb einer Entnahmeeinrichtung bewegt werden kann. Weitere Ausgestaltungen sind denkbar.

Weiterhin kann jeder Vertiefung eine eindeutige Nummer zugeordnet werden, wodurch eine spätere Identifikation des individualisierten klassifizierten Saatgutkorns ermöglicht wird. Aufgrund der Zuordnung einer eindeutige Nummer zu jeder Vertiefung können damit Einzelkörner in einem Proberöhrchen oder einer anderen geeigneten Aufbewahrungseinrichtung individuell mit einem Etikett versehen werden, wobei in Folge dieser eindeutigen Zuordnung ein Etikettierungsprozess sogar automatisch vorgenommen werden kann. Auf dem Etikett können die Eigenschaften des damit etikettierten Saatgutkorns unmittelbar vermerkt werden. Alternativ oder zusätzlich kann direkt eine Klassifikationsbezeichnung angegeben und/oder ein Barcode eingesetzt werden, durch dessen Auslesung auf die zugehörigen Eigenschaften des individualisierten Saatgutkorns zugegriffen werden kann.

Weiterhin kann die Vornahme eines manuellen Entnahmevorgangs vorteilhaft sein. In einer besonderen Ausgestaltung kann hierzu eine zusätzliche Platte vorgesehen sein, welche über eine optisch steuerbare Anzeigeeinrichtung verfügen und welche insbesondere im Wesentlichen parallel unterhalb der Saatgutkörner enthaltenden transparenten Ablage angeordnet sein kann. Die optisch steuerbare Anzeigeeinrichtung kann hierzu bevorzugt über eine Matrix an bedienbaren Leuchteinrichtungen, insbesondere an Leuchtdioden (*light emitting diodes*, LEDs) verfügen, wobei vorzugsweise jeder Vertiefung genau eine Leuchteinrichtung zugeordnet ist. Auf diese Weise kann eine Position einer Vertiefung, in welcher sich das gewünschte, zu entnehmende Saatgutkorn befindet und welcher gleichzeitig eine eindeutige Nummer zugeordnet ist, mittels der optisch steuerbaren Anzeigeeinrichtung in eindeutiger Weise angezeigt werden, um so einem Nutzer zuverlässig die Position des ausgewählten Saatgutkornes anzuzeigen. Damit lassen sich Fehler bei der Entnahme des individuellen Saatgutkornes weitgehend vermeiden.

Das vorgeschlagene System kann weiterhin eine elektronische Steuereinrichtung umfassen, welche insbesondere zur Steuerung des Systems, vorzugsweise des Transports des Saatgutkornes von dem Vorrat zur Aufnahmeeinrichtung, eingerichtet sein kann. Darüber hinaus kann die elektronische Steuereinrichtung auch über eine oder mehrere weitere Module verfügen, welche für weitere Aufgaben eingerichtet sein können. Dazu gehören insbesondere eine Steuerung der Vornahme des Bereitstellungsvorgangs des Vorrats, des Vereinzelungsvorgangs, des Wiegevorgangs, des Messvorgangs des Sortiervorgangs, und/oder des Entnahmevorgangs. Weiterhin kann die elektronische Steuereinrichtung die Steuerung der oben beschrieben Zuordnung einer eindeutigen Nummer zu jeder Vertiefung in der Ablage der Aufnahmeeinrichtung zur Identifikation der individualisierten klassifizierten Saatgutkörner vornehmen.

Darüber hinaus kann die elektronische Steuereinrichtung auch zur Darstellung von ermittelten Messdaten aus der Messeinrichtung, der Wiegeeinrichtung und/oder gegebenenfalls weiteren Einrichtungen, insbesondere in Echtzeit, eingesetzt werden. Beispielsweise können hierzu auch nach oder auch bereits während des Verfahrens zum Sortieren einer Vielzahl von Saatgutkörnern einem Nutzer gewonnene Messdaten direkt und/oder in aufbereiteter Form, etwa als Histogramme oder in Form statistischer Analysen, bereitgestellt werden. Auf diese Weise lassen sich insbesondere Schwellenwerte, welche zur Klassifikation der Vielzahl der Saatgutkörner eingesetzt werden, nach oder auch bereits während eines laufenden Sortierverfahrens anpassen. Ebenso kann auf diese Weise eine Fernüberwachung (*remote control*) des vorliegenden Systems und des zugehörigen Verfahrens ermöglicht werden.

In einem weiteren Aspekt betrifft die vorliegende Erfindung ein Verfahren zum Sortieren einer Vielzahl von Saatgutkörnern, welches mindestens die im Folgenden beschriebenen Verfahrensschritte a) bis c) umfasst, wobei die Verfahrensschritte a) bis d) so oft wiederholt werden, bis alle Saatgutkörner sortiert sind oder das Verfahren vorher durch eine unwillkürliche Blockierung im System oder durch eine willkürliche Beendigung des Verfahrens abgebrochen wird. Die Verfahrensschritte im Einzelnen sind:
a) Vereinzelung von Saatgutkörnern aus einer Vielzahl von bereitgestellten Saatgutkörnern;
b) Einführen des vereinzelten Saatgutkornes in eine Probenvorrichtung, wobei die Probenvorrichtung zur Einführung eines vereinzelten Saatgutkornes in eine Messeinrichtung, welche zur Klassifikation des vereinzelten Saatgutkornes einsetzbar ist, eingerichtet ist;
c) Bestimmen eines Gewichts eines vereinzelten Saatgutkornes, wobei die vereinzelten Saatgutkörner jeweils einzeln mechanisch einer Wiegeeinrichtung zur Ermittlung eines Gewichts des vereinzelten Saatgutkornes zugeführt werden, wobei die Wiegeeinrichtung eine Präzisionswaage ist; und
d) Einbringen des klassifizierten Saatgutkornes mittels einer Einfülleinrichtung in eine Aufnahmeeinrichtung;
wobei das Saatgutkorn zumindest teilweise auf pneumatischem Wege aus einem Vorrat nacheinander zu verschiedenen Einrichtungen, welche jeweils zur Durchführung eines der Verfahrensschritte eingerichtet sind, transportiert wird, und wobei Verfahrensschritt c) nach Verfahrensschritt a) und vor Verfahrensschritt d) durchgeführt wird.

Hierbei können in vorteilhafter Weise die Verfahrensschritte a) bis d) für ein einzelnes Saatgutkorn nacheinander in der angegebenen Reihenfolge, beginnend mit Verfahrensschritt a), darauffolgend mit Verfahrensschritt b), mit Verfahrensschritt c) und Verfahrensschritt mit Schritt d), ausgeführt werden, wobei die Verfahrensschritte a) bis d) für aufeinanderfolgende Saatgutkörner zumindest teilweise auch gleichzeitig durchgeführt werden. Beispielsweise kann hierbei ein ausgewähltes Saatgutkorn in Verfahrensschritt a) vereinzelt werden, während gleichzeitig ein zuvor in Verfahrensschritt a) vereinzeltes Saatgutkorn gleichzeitig gemäß Verfahrensschritt b) klassifiziert wird. Weitere Möglichkeiten sind denkbar.

In einer besonderen Ausgestaltung können, insbesondere die einzelnen Schritte in Form eines Taktes durchführen zu können, jeweils geeignete Zeitintervalle vorgesehen werden, denen jeweils die Ausführung der Schritte zugeordnet werden, wobei zwischen zwei Schritten auch Pausen in der Ausführung vorgesehen sein können. Beispielsweise können für die Klassifikation eines ersten Saatgutkorns gemäß Verfahrensschritt b) zwei aufeinanderfolgende Zeitintervalle vorgesehen sein, wobei während des ersten Zeitintervall ein zweites Saatgutkorn gemäß Verfahrensschritt a) einer Vereinzelung unterzogen wird, während das zweite Saatgutkorn im zweiten Zeitintervall ruht. Weitere Möglichkeiten sind denkbar.

Zur Durchführung des erfindungsgemäßen Verfahrens kann hierbei die oben beschrieben elektronisch steuerbare Einrichtung vorgesehen sein, welche einen Programmcode, der zur Durchführung des Verfahrens eingerichtet ist, aufweist.

In einer besonders bevorzugten Ausgestaltung kann das erfindungsgemäße Verfahren mittels des oben beschriebenen Systems zum Sortieren einer Vielzahl von Saatgutkörnern ausgeführt werden.

Für weitere Einzelheiten in Bezug auf das Verfahren wird auf die übrige Beschreibung, insbesondere zum System und zur Probenvorrichtung, verwiesen.

In einem weiteren Aspekt betrifft die vorliegende Erfindung eine Verwendung eines hier vorgestellten Systems für eine automatisierte Hochdurchsatz-Sortierung von Saatgutkörnern unter Einsatz einer Messeinrichtung, welche für Untersuchungen der Saatgutkörner eingerichtet ist, insbesondere für Untersuchungen mittels eines Verfahrens der kernmagnetischen Resonanz und/oder eines optischen Messverfahrens. Der Begriff der "Hochdurchsatz-Sortierung" bezeichnet hierbei eine Sortierung von mindestens 300, bevorzugt von mindestens 600, besonders bevorzugt von mindestens 1000 Einzelkörnern pro Stunde, möglichst auf vollautomatische Weise, wobei die Sortierung der Samenkörner zu einer Bereitstellung von mindestens zwei Fraktion an Einzelkörnern mit unterschiedlichen Eigenschaften führen kann und/oder eine Bereitstellung von einzeln klassifizierten und individuell zugänglichen Saatkörnern ermöglichen kann.

Das vorliegende System eignet sich somit für ein weites Spektrum an Anwendungen in der Pflanzenzüchtung und -forschung, beispielsweise für den Einsatz in der Sortierung von haploiden und hybriden Maiskörnern. Bevorzugte Anwendungen können Maiskörner an Hand des Ölgehalts betreffen, welche aus Kreuzungen eines Induktors und eines maternalen Elters, die sich in ihrem Ölgehalt stark voneinander unterscheiden, hervorgegangen sind, wie in der Publikation von Melchinger, A.E., W. Schipprack, H. F. Utz, V. Mirdita, In Vivo Haploid Induction in Maize: Identification of Haploid Seeds by Their Oil Content, Crop Sci. 54, 2014, S. 1497-1504, beschrieben. Ebenso kann es sich zur Sortierung von Selbstungs- und Kreuzungssamen in der Produktion von Hybriden von Ölpflanzen zwischen Kreuzungen zweier Eltern, die sich in ihrem Ölgehalt deutlich voneinander unterscheiden, eignen, wie beispielsweise für Jatropha von Montes, J. M., Bulach, A., Martin, M., & Senger, E., Quantitative Trait Variation in Self- and Cross-Fertilized Seeds of Jatropha curcas L.: Parental Effects of Genotypes and Genetic Pools, BioEnergy Research, 2015, doi:10.1007/s12155-014-9576-8, vorgeschlagen. Weitere Anwendungen können eine Qualitätskontrolle von Saatgutkörnern oder, alternativ, von Pillen in der pharmazeutischen Industrie betreffen.

### Kurze Beschreibung der Figuren

Bevorzugte Ausführungsbeispiele der vorliegenden Erfindung sind in den Figuren dargestellt und werden in der nachfolgenden Beschreibung ohne Beschränkung der Allgemeinheit näher erläutert. Hierbei zeigen:
- Figur 1: eine schematische Darstellung eines bevorzugten Ausführungsbeispiels für ein erfindungsgemäßes System zum Sortieren einer Vielzahl von Saatgutkörnern;
- Figur 2: ein bevorzugtes Ausführungsbeispiel für eine erfindungsgemäße Probenvorrichtung; und
- Figur 3: ein bevorzugtes Ausführungsbeispiel für eine erste erfindungsgemäße Aufnahmeeinrichtung; und
- Figur 4A und 4B: ein bevorzugtes Ausführungsbeispiel für eine zweite erfindungsgemäße Aufnahmeeinrichtung.

### Ausführungsformen der Erfindung

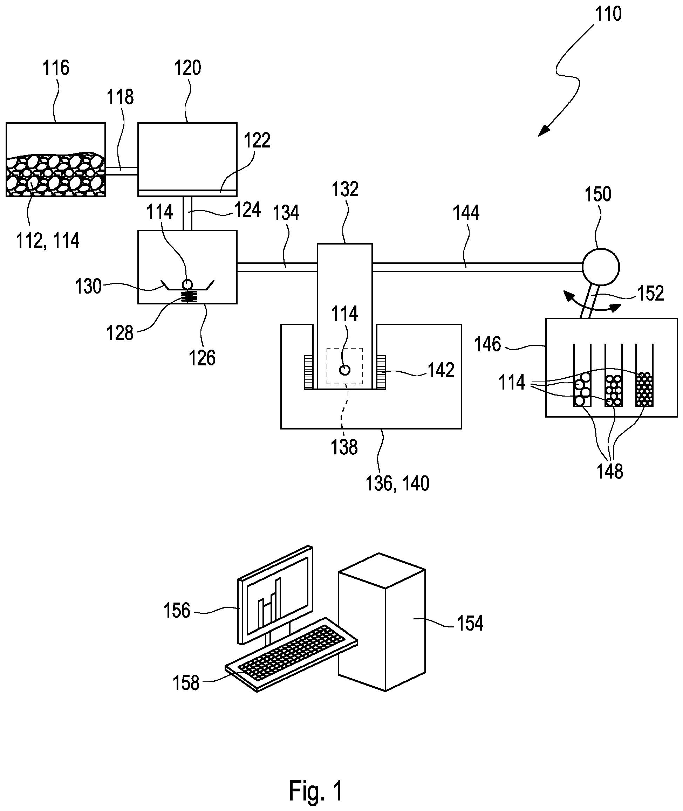

Figur 1 zeigt schematisch ein bevorzugtes Ausführungsbeispiel für ein erfindungsgemäßes System 110 zum Sortieren einer Vielzahl 112 von Saatgutkörnern 114. Die Vielzahl 112 der Saatgutkörner 114 wird in diesem Ausführungsbeispiel in Form eines Vorrats 116 bereitgestellt, aus welchem jeweils ein Teil der Saatgutkörner 114 mittels einer ersten Transporteinrichtung 118 einer Vereinzelungsvorrichtung 120 zugeleitet werden, welche zur Vereinzelung der Saatgutkörner 114 aus der Vielzahl 112 der bereitgestellten Saatgutkörner 114 eingerichtet ist. Die zwischen dem Vorrat 116 und der Vereinzelungsvorrichtung 120 befindliche erste Transporteinrichtung 118 kann hierbei die Saatgutkörner 114 auf mechanischem Wege, insbesondere durch Wirkung der Schwerkraft, und/oder auf pneumatischem Wege, insbesondere mittels einer Beaufschlagung mit Druckluft und/oder durch einen Absaugvorgang, der Vereinzelungsvorrichtung 120 zuleiten. Die Vereinzelungsvorrichtung 120 kann hierbei vorzugsweise gemäß der Veröffentlichung von Karayel et al., s.o., ausgestaltet sein und, insbesondere um eine möglichst lange, ungestörte Durchführung des hier vorgeschlagenen Sortierverfahrens zu ermöglichen, zusätzlich mit einer Vibrationseinrichtung 122 versehen werden. Experimentelle Untersuchungen haben gezeigt, dass damit eine Blockierung der Vereinzelungsvorrichtung 120, etwa durch eine Verstopfung mit Saatgutkörnern 114, und damit des gesamten Systems 110 weitgehend vermieden werden kann.

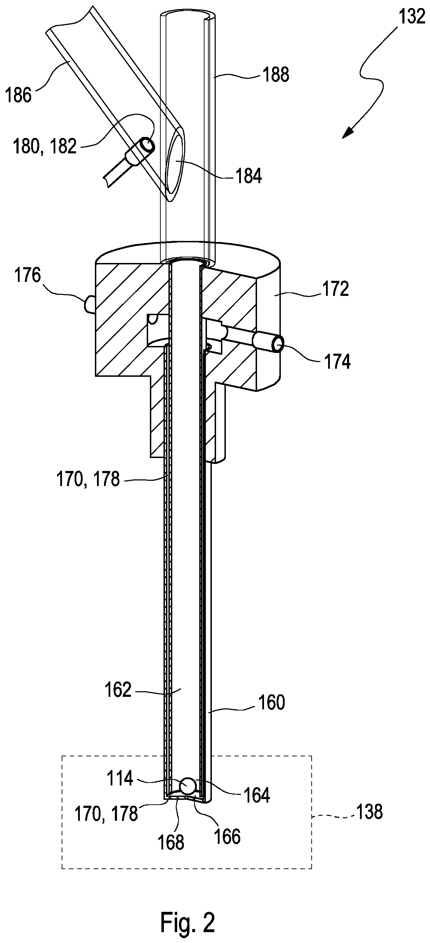

Mittels einer zweiten Transporteinrichtung 124 können die in der Vereinzelungsvorrichtung 120 vereinzelten Saatgutkörner 114 jeweils einzeln einer Wiegeeinrichtung 126 zur Ermittlung eines Gewichts eines vereinzelten Saatgutkornes 114 zugeführt werden. Das vereinzelte Saatgutkorn 114 kann hierbei aus der Vereinzelungseinrichtung 120 mittels Schwerkraft auf die Wiegeeinrichtung 126 geführt werden, wobei die Wiegeeinrichtung 126 in diesem Ausführungsbeispiel eine Dämpfungseinrichtung 128 aufweist, welche zur Verminderung eines durch das Saatgutkorn 114 auf die Wiegeeinrichtung 126 ausgelösten Kraftstoßes eingerichtet ist. Andere Ausgestaltungen, etwa durch eine Zuführung durch mechanisches Bewegen (Schieben) über eine Oberfläche einer ebenen Platte (nicht dargestellt), sind ebenfalls möglich. Auf diese Weise kann eine Überladung der Wiegeeinrichtung 126 vermieden werden, welche durch ein auf eine Präzisionswaage 130 fallendes Saatgutkorn 114 bzw. durch eine Entstehung von Luftdruck nach einer Entnahme des Saatgutkorns 114 von der Präzisionswaage 130 entstehen kann. Alternativ kann das vereinzelte Saatgutkorn 114 auch zunächst einer Probenvorrichtung 132 zugeleitet werden, bevor es der Wiegeeinrichtung 126 zugeführt wird oder ohne dass eine Wägung vorgenommen wird und hierbei die Wiegeeinrichtung 126 vollständig entfallen kann. Die zweite Transporteinrichtung 124 fällt dann mit einer dritten Transporteinrichtung 134, welche das vereinzelte Saatkorn 114 zur Probenvorrichtung 132 zusammen.
Die Probenvorrichtung 132 ist erfindungsgemäß zur Einführung des vereinzelten Saatgutkornes 114 in eine Messeinrichtung 136, welche zu einer Klassifikation des vereinzelten Saatgutkornes 114 einsetzbar ist. Mittels der Probenvorrichtung 132 kann das vereinzelte Saatgutkorn 114 als Probe derart in einen Probenraum 138 der Messeinrichtung 136 eingebracht werden kann, dass hierdurch an dem vereinzelten Saatgutkorn 114 eine Untersuchung auf mindestens eine gewünschte Eigenschaft durchgeführt wird, woraufhin das vereinzelte Saatgutkorn 114 nunmehr auch als klassifiziertes Saatgutkorn 114 bezeichnet wird. Die hier dargestellte Probenvorrichtung 136 ist derart ausgestaltet, dass die Untersuchung des vereinzelten Saatgutkornes 114 innerhalb des Probenraums 138 zu einem möglichst reproduzierbaren Ergebnis mit möglichst hohem Signal-Rausch-Verhältnis führt. Eine besonders bevorzugte Ausführungsform der Probenvorrichtung ist in Figur 2 schematisch dargestellt.

Da in dem vorliegenden Ausführungsbeispiel die Messeinrichtung 136 als NMR-Messeinrichtung 140 zur Durchführung von Verfahren der kernmagnetischen Resonanz (NMR-Verfahren) bzw. von bildgebenden NMR-Verfahren (NMR-Imaging; MRI-Verfahren) eingerichtet ist, befindet sich der Probenraum 138 innerhalb einer Hochfrequenzspule 142 der NMR-Messeinrichtung 140, in dem sich ein möglichst homogenes Magnetfeld ausbildet, in welches das vereinzelte Saatgutkorn 114 für die Untersuchung auf die mindestens eine gewünschte Eigenschaft eingebracht ist. Alternativ oder zusätzlich ist ein Einsatz einer anderen Messeinrichtung möglich, insbesondere einer optischen Messeinrichtung, welche zur Durchführung von spektroskopischen Verfahren in einem optischen oder einem hieran angrenzenden Spektralbereich, vorzugsweise im Infrarot (NIS), insbesondere im Nahinfrarot (NIRS), eingerichtet ist.

Während die dritte Transporteinrichtung 134, welche das vereinzelte Saatkorn 114 zur Probenvorrichtung 132 befördert, ebenfalls auf mechanischem Wege, insbesondere durch Wirkung der Schwerkraft, und/oder auf pneumatischem Wege, insbesondere mittels einer Beaufschlagung mit Druckluft, betrieben werden kann, wird, wie in Figur 2 dargestellt, das vereinzelte Saatkorn 114 auf pneumatischem Wege, insbesondere mittels einer Beaufschlagung mit Druckluft, mittels einer vierten Transporteinrichtung 144 zu einer Aufnahmeeinrichtung 146 zur Aufnahme des klassifizierten Saatgutkornes 114 befördert. In einer besonderen Ausführung kann das vereinzelte Saatkorn 114 zunächst der Wiegeeinrichtung 126, welche in diesem Fall zwischen der Probenvorrichtung 132 und der Aufnahmeeinrichtung 146 angeordnet ist, zugeführt werden, bevor es der Aufnahmeeinrichtung 146 zugeleitet wird.

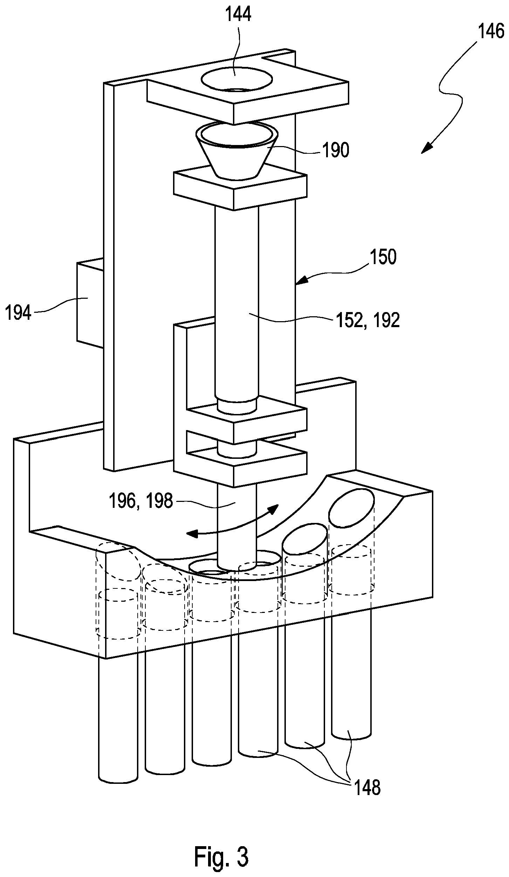

In der in Figur 1 schematisch dargestellten Ausführung des erfindungsgemäßen Systems verfügt die Aufnahmeeinrichtung 146 über drei zur Aufnahme des klassifizierten Saatgutkornes 114 eingerichtete Behälter 148. Die Zahl der Behälter 148 kann hierbei je nach einer gewünschten Art der Klassifikation der Vielzahl 112 der Saatgutkörner 114 festgelegt werden. Vorzugsweise sind, wie Figur 1 zeigt, die Behälter 148 nebeneinander angeordnet sind, so dass das klassifizierte Saatgutkorn 114 mittels einer Schwenkeinrichtung 150 in einen der Behälter 148 einbringbar ist. Ein Transport des vereinzelten Saatgutkornes 114 zwischen der Schwenkeinrichtung 150 und den Behältern 148 mittels einer beweglichen fünften Transporteinrichtung 152 kann hierbei ebenfalls auf mechanischem Wege, insbesondere durch Wirkung der Schwerkraft, und/oder auf pneumatischem Wege, insbesondere mittels einer Beaufschlagung mit Druckluft, erfolgen. In einer alternativen Ausgestaltung kann die Aufnahmeeinrichtung 146 gemäß der schematischen Darstellung in Figur 3 ausgestaltet sein.

In dem vorliegenden Ausführungsbeispiel weist das erfindungsgemäße System 110 weiterhin eine elektronische Steuereinrichtung 154 zur Steuerung des vorliegenden Systems 110 auf. Die elektronische Steuereinrichtung 154 ist hierbei insbesondere zur Steuerung des Transports des Saatgutkornes 114 von dem Vorrat 116 zur Aufnahmeeinrichtung 146 eingerichtet. Darüber hinaus verfügt hier die elektronische Steuereinrichtung 154 über mehrere weitere Module, welche für weitere Aufgaben eingerichtet sind. Dazu gehören insbesondere eine Steuerung des Vorrats 116, der Vereinzelungseinrichtung 120, der Wiegeeinrichtung 126, der Probenvorrichtung 132, der Messeinrichtung 136, der Schwenkeinrichtung 150 und der Transporteinrichtungen 118, 124, 134, 144, 152.

Darüber hinaus kann die elektronische Steuereinrichtung 154 auch über einen Monitor 156 zur Darstellung von ermittelten Messdaten aus der Messeinrichtung 136 und/oder der Wiegeeinrichtung 126, insbesondere in Echtzeit, verfügen. Beispielsweise können hierzu bereits während einer Durchführung des Sortierverfahrens gewonnene Messdaten direkt und/oder in aufbereiteter Form, etwa als Histogramme oder in Form statistischer Analysen, auf dem Monitor 156 bereitgestellt werden. Damit können insbesondere Schwellenwerte, welche zur Klassifikation der Vielzahl 112 der Saatgutkörner 114 verwendet werden, auch bereits während eines laufenden Sortierverfahrens angepasst werden, etwa durch eine Eingabe mittels einer Tastatur 158. Alternativ oder zusätzlich kann auf diese Weise eine Fernüberwachung (*remote control*) des Systems 110 durchgeführt werden.

Figur 2 zeigt ein besonders bevorzugtes Ausführungsbeispiel für eine erfindungsgemäße Probenvorrichtung 132. Die hier dargestellte Probenvorrichtung umfasst ein äußeres Röhrchen 160, welches zur Aufnahme der Probenvorrichtung 132 in die Messeinrichtung 136 eingerichtet ist, sowie ein inneres Röhrchen 162 zur Aufnahme des vereinzelten Saatgutkornes 114, wobei das innere Röhrchen 162 in das äußere Röhrchen 160 eingeführt ist. Das äußere Röhrchen 160 verfügt hierbei über ein Volumen 164, welches sich nach Aufnahme der Probenvorrichtung 132 in die Messeinrichtung 136 innerhalb des Probenraums 138 der Messeinrichtung 136 befindet, um sicherzustellen, dass sich das in dem Volumen 164 befindliche Saatgutkorn 114 gleichzeitig in dem Probenraum 138 der Messeinrichtung 136 vorliegt.

Das vereinzelte Saatgutkorn 114, welches zur Untersuchung in den Probenraum 138 der Messeinrichtung 136 eingebracht werden soll, kann in dieser Ausführung über das innere Röhrchen 162 hindurch in das Volumen 164 des äußeren Röhrchens 160, welches sich gleichzeitig in dem Probenraum 138 der Messeinrichtung 136 befindet, eingebracht werden. Zur möglichst genauen Positionierung des vereinzelten Saatgutkorns 114 in dem Probenraum 138 kann das vereinzelte Saatgutkorn 114, insbesondere durch seine Schwerkraft, aus dem inneren Röhrchen 162, welches unten über eine Öffnung 166 verfügt, wobei sich die untere Öffnung 166 vorzugsweise innerhalb des Volumens 164 des äußeren Röhrchens 160 befindet, in das äußere Röhrchen 160, welches einen unten geschlossenen Boden 168 aufweist, gelangen.

In dem in Figur 2 dargestellten Ausführungsbeispiel weisen sowohl das äußere Röhrchen 160 als auch das innere Röhrchen 162 eine runde Querschnittsfläche auf, wobei das innere Röhrchen 162 zudem zentriert in das äußere Röhrchen 160 eingebracht ist. Dadurch bildet sich zwischen dem äußeren Röhrchen 160 und dem inneren Röhrchen 162 ein ringförmiger Zwischenraum 170 aus. Ist das Volumen 164 nun ebenfalls zentriert oberhalb des geschlossenen Bodens 168 des äußeren Röhrchens 160 angeordnet, so lässt sich das vereinzelte Saatgutkorn 114 direkt in den zentrierten Probenraum 138 einbringen.

Um insbesondere nach einem erfolgten Messvorgang das vereinzelte und mittels der Messeinrichtung zumindest teilweise klassifizierte Saatgutkorn 114 wieder aus dem Volumen 164 der Probenvorrichtung 132 zu entfernen, ist der Zwischenraum 170 für eine pneumatische Behandlung des zumindest teilweise klassifizierten Saatgutkorns 114, insbesondere zur Zuführung von Druckluft in das äußere Röhrchen 160, eingerichtet. In der vorliegenden Ausführung verfügt die Probenvorrichtung 132 über eine Anschlussvorrichtung 172, welche eine Aufnahme für das äußere Röhrchen 160 und das innere Röhrchen 162 aufweist, welche derart ausgestaltet ist, dass sich zwischen dem äußeren Röhrchen 160 und dem inneren Röhrchen 162 der beschriebene ringförmige Zwischenraum 170 auszubilden kann. Darüber hinaus sind in der Anschlussvorrichtung 172 ein Einlass 174, ein Auslass 176 sowie ein Kanal 178 für die Druckluft vorgesehen. Die Anschlussvorrichtung 172 ist, wie in Figur 2 dargestellt, so eingerichtet, dass eine form- und kraftschlüssige Verbindung zwischen der Probenvorrichtung 132 und einer zur Einbringung der Probenvorrichtung 132 in die Messeinrichtung 136 vorgesehenen Aufnahme der Messeinrichtung 136 entsteht.

Durch eine pneumatische Behandlung, vorzugsweise durch eine Beaufschlagung mit der Druckluft und/oder durch Vornahme eines Absaugvorgangs, lässt sich somit das vereinzelte Saatgutkorn 114 aus dem äußeren Röhrchen 160 durch das innere Röhrchen 162 hindurch aus der Probenvorrichtung 132 heraus in die Aufnahmeeinrichtung 146 für das klassifizierte Saatgutkorn 114 führen. Um hierbei sicherzustellen, dass das klassifizierte Saatgutkorn 114 auch tatsächlich der Aufnahmeeinrichtung 146 zugeleitet wird und nicht etwa fälschlicherweise wieder zurück zur Wiegeeinrichtung 126 gelangen kann, weist die Probenvorrichtung 132 hier eine Einstellvorrichtung 180 in Form eines Luftschleiers 182 auf, mittels welcher sich eine Öffnung 184 zwischen einem Eingang 186 der Probenvorrichtung 132 für das vereinzelte Saatgutkorn 114 und einem Ausgang 188 der Probenvorrichtung 132 für das klassifizierte Saatgutkorn 114 steuern lässt.

Figur 3 zeigt ein bevorzugtes Ausführungsbeispiel für eine erste erfindungsgemäße Aufnahmeeinrichtung 146. Die hier dargestellte erste Aufnahmeeinrichtung 146 verfügt über sechs zur Aufnahme des klassifizierten Saatgutkornes 114 eingerichtete Behälter 148. Wie bereits erwähnt, kann die Zahl der Behälter 148 je nach der gewünschten Art der Klassifikation der Vielzahl 112 der Saatgutkörner 114 festgelegt werden. Wie Figur 3 weiterhin zeigt, sind die Behälter 148 nebeneinander angeordnet, so dass das klassifizierte Saatgutkorn 114 mittels der Schwenkeinrichtung 150 in einen der Behälter 148 einbringbar ist.

Das bereits der klassifizierte Saatgutkorn 114 wird hierbei mittels der hier pneumatisch betriebenen vierten Transporteinrichtung 144 aus der Probenvorrichtung 132 der Schwenkeinrichtung 150 ebenfalls auf pneumatischem Wege, insbesondere durch Beaufschlagung mit der Druckluft, zugeleitet. Die in Figur 3 dargestellte exemplarische Schwenkeinrichtung 150 weist einen Trichter 190 zur Aufnahme des klassifizierten Saatgutkorns 114 auf, welches dadurch in die bewegliche fünfte Transporteinrichtung 152, die hier in Form eines flexiblen Röhrchens 192 ausgestaltet ist, gelangen kann. Mittels eines Schrittmotors 194 lässt sich die Schwenkeinrichtung 150 derart bewegen, dass dadurch ein Führungskopf 196 eine Funktion als erste Einfülleinrichtung 198 zur Verteilung und Einbringung des klassifizierten Saatgutkornes 114 in einen der Behälter 148 der ersten Aufnahmeeinrichtung 146 übernimmt.

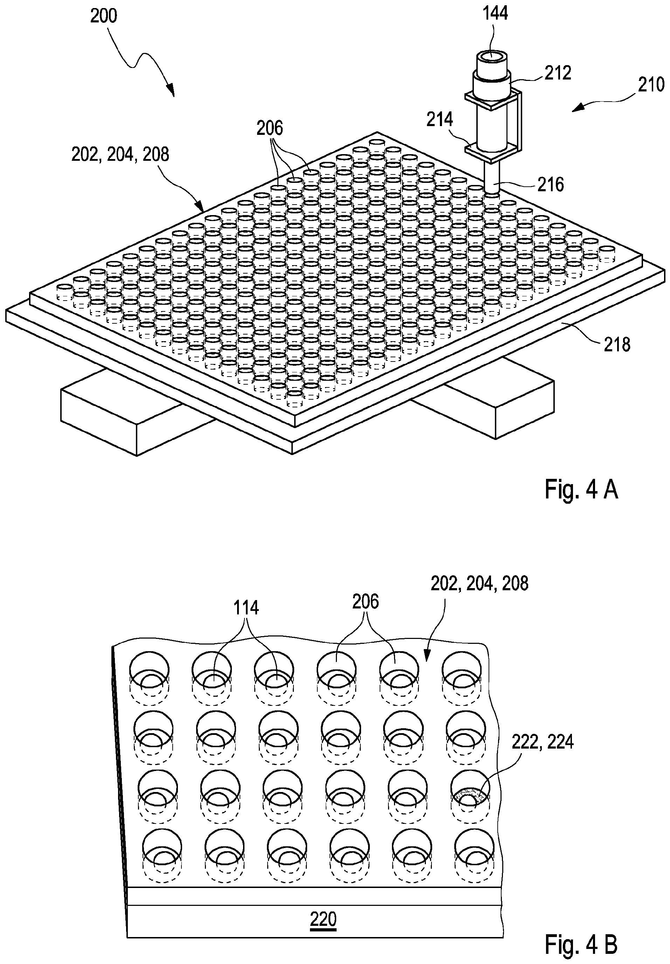

Figur 4 zeigt ein bevorzugtes Ausführungsbeispiel für eine zweite erfindungsgemäße Aufnahmeeinrichtung 200. Die hier dargestellte exemplarische zweite Aufnahmeeinrichtung 200 weist eine Ablage 202 zur Aufnahme der klassifizierten Saatgutkörner 114 auf, wobei hier die Ablage 202 eine Platte 204 umfasst, welche in dieser Ausführung über 300 Vertiefungen 206, die auch als "Wells" bezeichnet werden, zur Aufnahme jeweils genau eines klassifizierten Saatgutkornes 114 in genau eine Vertiefung 206 verfügt. Wie aus Figur 4A hervorgeht, sind hierbei die Vertiefungen 206 in Form einer Matrix 208 mit 20 x 15 Vertiefungen 206 über die Platte 204 verteilt. Als Material für die Platte dient hier ein mechanisch stabiler, transparenter Kunststoff. Andere Dimensionen und Materialien für die Platte 204 sind je nach gewünschtem Anwendungszweck und der Anzahl der zu sortierenden Saatgutkörner 114 möglich.

Zur Vornahme des Sortiervorgangs wird in dieser Ausführung das klassifizierte Saatgutkorn 114 mittels einer durch Druckluft bedienbaren zweiten Einfülleinrichtung 210 in die ausgewählte Vertiefung 206 eingebracht. Das bereits klassifizierte Saatgutkorn 114 wird hierbei mittels der pneumatisch betriebenen vierten Transporteinrichtung 144 aus der Probenvorrichtung 132 der zweiten Einfülleinrichtung 210 zugeleitet. Die zweite Einfülleinrichtung 210 umfasst hierzu, wie in Figur 4A dargestellt, eine Druckluftkopplung 212, einen Luftverteiler 214 und einen Einfüllkopf 216. Weiterhin ist hier eine bewegliche Plattform 218 vorgesehen, mittels welcher die Platte 204 innerhalb einer Ebene bewegt werden kann, um auf diese Weise die zur Füllung mit dem bestimmten Saatgutkorn 114 ausgewählte Vertiefung 206 möglichst direkt unterhalb die zweite Einfülleinrichtung 210 zu bringen.

Die Entnahme eines bestimmten ausgewählten individualisierten klassifizierten Saatgutkorns 114 aus der Platte 204 kann in dieser Ausführung durch eine pneumatische Austragung des ausgewählten Saatgutkornes 114 in ein Proberöhrchen, bevorzugt durch eine Beaufschlagung des Saatgutkornes 114 mittels Druckluft, erfolgen. Hierzu ist am Boden jeder Vertiefung 206 der Platte 204 eine kleine Öffnung vorgesehen, durch welche die zur Entnahme des ausgewählten Saatgutkornes 114 erforderliche Druckluft vorzugsweise von unten in die jeweilige Vertiefung 206 eingebracht werden kann. Auch zur Entnahme des Saatgutkorns 114 lässt sich die in Figur 4A dargestellte bewegliche Plattform 218 entsprechend einsetzen.

Alternativ oder zusätzlich kann das bestimmte ausgewählte individualisierte klassifizierte Saatgutkorn 114 auch manuell aus der Platte 204 entnommen werden. Hierzu kann vorteilhaft die in Figur 4B dargestellt Ausführung eingesetzt werden, welche über eine zusätzliche Platte 220 verfügt, die im Wesentlichen parallel unterhalb der die Saatgutkörner 114 enthaltenden transparenten Platte 204 angeordnet ist und eine optisch steuerbare Anzeigeeinrichtung 222 aufweist. Die optisch steuerbare Anzeigeeinrichtung 222 verfügt über eine Matrix an bedienbaren an Leuchtdioden (LEDs) 224, wobei jeder Vertiefung 206 genau eine Leuchtdiode 224 zugeordnet sein kann. Auf diese Weise diejenige Vertiefung 206, in welcher sich das gewünschte, zu entnehmende Saatgutkorn befindet, mittels der optisch steuerbaren Anzeigeeinrichtung 222 in eindeutiger Weise angezeigt werden, um so einem Nutzer zuverlässig das ausgewählte Saatgutkorn 114 anzuzeigen. Damit lassen sich Fehler bei der Entnahme des individuellen Saatgutkornes 114 weitgehend vermeiden.

**Liste der Bezugszeichen**

| | | | |
|---|---|---|---|
| 110 | System | 170 | Zwischenraum |
| 112 | Vielzahl | 172 | Anschlussvorrichtung |
| 114 | Saatgutkorn | 174 | Einlass für Druckluft |
| 116 | Vorrat | 176 | Auslass für Druckluft |
| 118 | (erste) Transporteinrichtung | 178 | Kanal für Druckluft |
| 120 | Vereinzelungseinrichtung | 180 | Einstellvorrichtung |
| 122 | Vibrationseinrichtung | 182 | Luftschleier |
| 124 | (zweite) Transporteinrichtung | 184 | Öffnung |
| 126 | Wiegeeinrichtung | 186 | Eingang der Probenvorrichtung |
| 128 | Dämpfungseinrichtung | 188 | Ausgang der Probenvorrichtung |
| 130 | Präzisionswaage | 190 | Trichter |
| 132 | Probenvorrichtung | 192 | flexibles Röhrchen |
| 134 | (dritte) Transporteinrichtung | 194 | Schrittmotor |
| 136 | Messeinrichtung | 196 | Führungskopf |
| 138 | Probenraum | 198 | (erste) Einfülleinrichtung |
| 140 | NMR-Messeinrichtung | 200 | (zweite) Aufnahmeeinrichtung |
| 142 | Hochfrequenzspule | 202 | Ablage |
| 144 | (vierte) Transporteinrichtung | 204 | Platte |
| 146 | (erste) Aufnahmeeinrichtung | 206 | Vertiefung |
| 148 | Behälter | 208 | Matrix |
| 150 | Schwenkeinrichtung | 210 | (zweite) Einfülleinrichtung |
| 152 | bewegliche (fünfte) Transporteinrichtung | 212 | Druckluftkopplung |
| | | 214 | Luftverteiler |
| 154 | elektronische Steuereinrichtung | 216 | Einfüllkopf |
| 156 | Monitor | 218 | bewegliche Plattform |
| 158 | Tastatur | 220 | zusätzliche Platte |
| 160 | äußeres Röhrchen | 222 | optisch steuerbare |
| 162 | inneres Röhrchen | | Anzeigeeinrichtung |
| 164 | Volumen | 224 | Leuchtdiode (LED) |
| 166 | untere Öffnung | | |
| 168 | geschlossener Boden | | |

## Patentansprüche

1. Probenvorrichtung (132) zur Einführung eines vereinzelten Saatgutkornes (114) in eine Messeinrichtung (136), welche zur Klassifikation des vereinzelten Saatgutkornes (114) einsetzbar ist, umfassend
- ein äußeres Röhrchen (160) zur Aufnahme der Probenvorrichtung (132) in die Messeinrichtung (136), wobei innerhalb eines Volumens (164) des äußeren Röhrchens (160) ein Probenraum (138) der Messeinrichtung (136) vorgesehen ist, wobei das äußere Röhrchen (160) über einen geschlossenen Boden (168) verfügt;
- ein inneres Röhrchen (162) zur Aufnahme eines vereinzelten Saatgutkornes (114), wobei das innere Röhrchen (162) in das äußere Röhrchen (160) eingeführt ist und eine untere Öffnung (166) aufweist, wodurch das vereinzelte Saatgutkorn (114) in das Volumen (164) des äußeren Röhrchens (160) einführbar ist; und
- einen Zwischenraum (170) zwischen dem äußeren Röhrchen (160) und dem inneren Röhrchen (162), wobei der Zwischenraum (170) derart eingerichtet ist, dass das vereinzelte Saatgutkorn (114) auf pneumatischem Wege aus dem äußeren Röhrchen (160) durch das innere Röhrchen (162) hindurch in eine Aufnahmeeinrichtung (146, 200) für ein klassifiziertes Saatgutkorn (114) austragbar ist.

2. Probenvorrichtung (132) nach dem vorangehenden Anspruch, ferner umfassend eine Einstellvorrichtung (180) zur Steuerung zwischen einem Eingang (186) für das vereinzelte Saatgutkorn (114) und einem Ausgang (188) zur Aufnahmeeinrichtung (146, 200) für das klassifizierte Saatgutkorn (114).

3. Probenvorrichtung (132) nach dem vorangehenden Anspruch, wobei zur Steuerung der Einstellvorrichtung (180) ein Luftschleier (182) vorgesehen ist.

4. Probenvorrichtung (132) nach einem der vorangehenden Ansprüche, wobei sich der Probenraum (138) zentriert oberhalb des Bodens (168) des äußeren Röhrchens (160) befindet und wobei das innere Röhrchen (162) zentriert in das äußere Röhrchen (160) eingebracht ist, wodurch das vereinzelte Saatgutkorn (114) zentriert in das Volumen (164) des äußeren Röhrchens (160) einführbar ist.

5. Probenvorrichtung (132) nach einem der vorangehenden Ansprüche, ferner umfassend eine Anschlussvorrichtung (172) zur Aufnahme des äußeren Röhrchens (160), des inneren Röhrchens (162) sowie eines Einlasses (174) und eines Auslasses (176) für einen Luftaustausch, wobei die Anschlussvorrichtung (172) derart ausgestaltet ist, dass sich dadurch ein ringförmiger Zwischenraum (170) zwischen dem äußeren Röhrchen (160) und dem inneren Röhrchen (162) ausbildet.

6. System (110) zum Sortieren einer Vielzahl (112) von Saatgutkörnern (114), umfassend
- mindestens eine Vereinzelungsvorrichtung (120) zur Vereinzelung von Saatgutkörnern (114) aus einer Vielzahl (112) von bereitgestellten Saatgutkörnern (114);
- mindestens eine Probenvorrichtung (132) nach einem der vorangehenden Ansprüche zur Einführung des vereinzelten Saatgutkornes (114) in eine Messeinrichtung (136), welche zur Klassifikation des vereinzelten Saatgutkornes (114) einsetzbar ist;
- mindestens eine Einfülleinrichtung (198, 210) zur Einbringung des klassifizierten Saatgutkornes (114) in eine Aufnahmeeinrichtung (146, 200); und
- mindestens eine Transporteinrichtung (118, 124, 134, 144, 152) zum zumindest teilweise pneumatischem Transport des Saatgutkornes (114) aus einem Vorrat (116) in die Vereinzelungsvorrichtung (120), aus der Vereinzelungsvorrichtung (120) in die Probenvorrichtung (132) und aus der Probenvorrichtung (132) in die Aufnahmeeinrichtung (146, 200).

7. System (110) nach dem vorangehenden Anspruch, ferner umfassend eine elektronische Steuereinrichtung (154) zur Steuerung des Transports des Saatgutkornes (114).

8. System (110) nach einem der beiden vorangehenden Ansprüche, wobei die Aufnahmeeinrichtung (146) mindestens zwei zur Aufnahme des mindestens einen klassifizierten Saatgutkornes (114) eingerichtete Behälter (148) umfasst, wobei die Behälter (148) nebeneinander angeordnet sind, wobei das klassifizierte Saatgutkorn (114) mittels einer Schwenkeinrichtung (150) in einen ausgewählten Behälter (148) einbringbar ist.

9. System (110) nach einem der drei vorangehenden Ansprüche, wobei die Aufnahmeeinrichtung (200) eine Ablage (202) zur Aufnahme der klassifizierten Saatgutkörner (114) umfasst, wobei die Ablage (202) über eine Anzahl an Vertiefungen (206) zur Aufnahme genau eines klassifizierten Saatgutkornes (114) verfügt, wobei jeder Vertiefung (206) eine eindeutige Nummer zugeordnet ist, wobei das klassifizierte Saatgutkorn (114) mittels der Einfülleinrichtung (198, 210) in eine ausgewählte Vertiefung (206) einbringbar ist.

10. System (110) nach einem der vier vorangehenden Ansprüche, ferner umfassend eine Wiegeeinrichtung (126) zur Ermittlung eines Gewichts eines vereinzelten Saatgutkornes (114), wobei die Transporteinrichtung (124, 134) ferner zum Transport des Saatgutkornes (114) in die Wiegeeinrichtung (126) und aus der Wiegeeinrichtung (126) eingerichtet ist.

11. Verfahren zum Sortieren einer Vielzahl (112) von Saatgutkörnern (114), mit den Verfahrensschritten:
a) Vereinzelung von Saatgutkörnern (114) aus einer Vielzahl (112) von bereitgestellten Saatgutkörnern (114);
b) Einführen des vereinzelten Saatgutkornes (114) in eine Probenvorrichtung (132), wobei die Probenvorrichtung (132) zur Einführung eines vereinzelten Saatgutkornes (114) in eine Messeinrichtung (136), welche zur Klassifikation des vereinzelten Saatgutkornes (114) einsetzbar ist, eingerichtet ist, nach einem der vorangehenden Ansprüche betreffend die Probenvorrichtung (132), und Klassifizieren des vereinzelten Saatgutkornes (114);
c) Bestimmen eines Gewichts eines vereinzelten Saatgutkornes (114), wobei die vereinzelten Saatgutkörner (114) jeweils mechanisch einzeln einer Wiegeeinrichtung (126) zur Ermittlung eines Gewichts des vereinzelten Saatgutkornes (114) zugeführt werden, wobei die Wiegeeinrichtung (126) eine Präzisionswaage (130) ist; und
d) Einbringen des klassifizierten Saatgutkornes (114) mittels einer Einfülleinrichtung (198, 210) in einer Aufnahmeeinrichtung (146, 200);
wobei das Saatgutkorn (114) aus einem Vorrat nacheinander zu verschiedenen Einrichtungen, welche jeweils zur Durchführung eines der Verfahrensschritte eingerichtet sind, zumindest teilweise auf pneumatischem Wege transportiert wird und wobei Verfahrensschritt c) nach Verfahrensschritt a) und vor Verfahrensschritt d) durchgeführt wird.

12. Verfahren nach dem vorangehenden Anspruch, wobei das Saatgutkorn (114) zunächst auf eine ebene Platte geführt wird, wobei ein Transport des vereinzelten Saatgutkornes (114) auf der ebenen Platte über eine seitliche mechanische Bewegung des Saatgutkornes (114) über die Oberfläche der ebenen Platte erfolgt.

13. Verfahren nach dem vorangehenden Anspruch, wobei die ebene Platte hierbei über mindestens zwei Öffnungen verfügt, wobei eine erste Öffnung für die Wiegeeinrichtung (126) und eine weitere Öffnung für die Zuführung zum Eingang in die Probenvorrichtung (132) vorgesehen ist.

14. Computerprogramm, welches dazu eingerichtet ist, um ein System nach Anspruch 7 dazu zu steuern, die Schritte des Verfahrens nach Anspruch 11 durchzuführen.

15. Verwendung eines Systems (110) nach einem der vorangehenden Ansprüche betreffend das System (110) für eine automatisierte Hochdurchsatz-Sortierung von Saatgutkörnern (114), einschließlich pillenförmiger Objekte, unter Einsatz einer Messeinrichtung (136), welche für Untersuchungen der Saatgutkörner (114) mittels eines Verfahrens der kernmagnetischen Resonanz (140) und/oder eines optischen Messverfahrens eingerichtet ist, oder für eine Qualitätskontrolle von Saatgutkörnern oder von Pillen in der pharmazeutischen Industrie.

## Claims

1. Sampling device (132) for introducing an individualized seed grain (114) into a measuring device (136), which can be used for the classification of the individualized seed grain (114), comprising
- an outer tube (160) for receiving the sampling device (132) into the measuring device (136), a sample chamber (138) of the measuring device (136) being provided within a volume (164) of the outer tube (160), the outer tube (160) having a closed bottom (168) ;
- an inner tube (162) for receiving an individualized seed grain (114), the inner tube (162) being inserted in the outer tube (160) and having a lower opening (166), whereby the individualized seed grain (114) can be introduced into the volume (164) of the outer tube (160); and
- an intermediate space (170) between the outer tube (160) and the inner tube (162), the intermediate space (170) being designated in such a way that the individualized seed grain (114) can be discharged by pneumatic means out of the outer tube (160) through the inner tube (162) into a receiving device (146, 200) for a classified seed grain (114).

2. Sampling device (132) according to the preceding claim, also comprising a setting device (180) for controlling between an inlet (186) for the individualized seed grain (114) and an outlet (188) to the receiving device (146, 200) for the classified seed grain (114).

3. Sampling device (132) according to the preceding claim, an air curtain (182) being provided for controlling the setting device (180).

4. Sampling device (132) according to any one of the preceding claims, the sample chamber (138) being located in a centered manner above the bottom (168) of the outer tube (160) and the inner tube (162) being inserted in the outer tube (160) in a centered manner, whereby the individualized seed grain (114) can be introduced into the volume (164) of the outer tube (160) in a centered manner.

5. Sampling device (132) according to any one of the preceding claims, also comprising a connection device (172) for receiving the outer tube (160), the inner tube (162) and also an inlet (174) and an outlet (176) for an air exchange, the connection device (172) being configured in such a way that an annular intermediate space (170) thereby forms between the outer tube (160) and the inner tube (162).

6. System (110) for sorting a plurality (112) of seed grains (114), comprising
- at least one individualizing device (120) for individualizing seed grains (114) from a plurality (112) of seed grains (114) provided;
- at least one sampling device (132) according to any one of the preceding claims for introducing the individualized seed grain (114) into a measuring device (136) that can be used for the classification of the individualized seed grain (114) ;
- at least one filling device (198, 210) for introducing the classified seed grain (114) into a receiving device (146, 200); and
- at least one transporting device (118, 124, 134, 144, 152) for the at least partially pneumatic transport of the seed grain (114) from a store (116) into the individualizing device (120), from the individualizing device (120) into the sampling device (132) and from the sampling device (132) into the receiving device (146, 200).

7. System (110) according to the preceding claim, also comprising an electronic control device (154) for controlling the transport of the seed grain (114) .

8. System (110) according to any one of the two preceding claims, the receiving device (146) comprising at least two containers (148) designated for receiving the at least one classified seed grain (114), the containers (148) being arranged next to one another, it being possible for the classified seed grain (114) to be introduced into a selected container (148) by means of a pivoting device (150).

9. System (110) according to any one of the three preceding claims, the receiving device (200) comprising a repository (202) for receiving the classified seed grains (114), the repository (202) having a number of depressions (206) for receiving precisely one classified seed grain (114), each depression (206) being assigned a unique number, it being possible for the classified seed grain (114) to be introduced into a selected depression (206) by means of the filling device (198, 210).

10. System (110) according to any one of the four preceding claims, also comprising a weighing device (126) for ascertaining a weight of an individualized seed grain (114), the transporting device (124, 134) also being designated for transporting the seed grain (114) into the weighing device (126) and out of the weighing device (126).

11. Method for sorting a plurality (112) of seed grains (114), with the method steps of:
a) individualizing seed grains (114) from a plurality (112) of seed grains (114) provided;
b) introducing the individualized seed grain (114) into a sampling device (132), the sampling device (132) being designated for introducing an individualized seed grain (114) into a measuring device (136) that can be used for the classification of the individualized seed grain (114), according to any one of the preceding claims concerning the sampling device (132), and classifying the individualized seed grain (114);
c) determining a weight of an individualized seed grain (114), the individualized seed grains (114) respectively being individually fed mechanically to a weighing device (126) for ascertaining a weight of the individualized seed grain (114), the weighing device (126) being a precision balance (130); and
d) introducing the classified seed grain (114) into a receiving device (146, 200) by means of a filling device (198, 210);
the seed grain (114) being transported at least partially by pneumatic means from a store successively to various devices that are respectively designated for carrying out one of the method steps, and method step c) being carried out after method step a) and before method step d).

12. Method according to the preceding claim, the seed grain (114) being carried first onto a planar plate, a transport of the individualized seed grain (114) taking place on the planar plate by way of a lateral mechanical movement of the seed grain (114) over the surface of the planar plate.

13. Method according to the preceding claim, the planar plate having here at least two openings, a first opening being provided for the weighing device (126) and another opening being provided for feeding to the inlet into the sampling device (132) .

14. Computer program which is configured to control a system according to Claim 7 to carry out the steps of the method according to Claim 11.

15. Use of a system (110) according to any one of the preceding claims concerning the system (110) for an automated high-throughput sorting of seed grains (114) including pill-shaped objects, by using a measuring device (136) which is designated for investigations of the seed grains (114) by means of a method of nuclear magnetic resonance (140) and/or an optical measuring method, or for quality control of seed grains or of pills in the pharmaceutical industry.

## Revendications

1. Dispositif d'échantillonnage (132) pour l'introduction d'une graine de semence séparée (114) dans un dispositif de mesure (136), qui peut être utilisé pour classer la graine de semence séparée (114), comprenant
- un tube extérieur (160) pour recevoir le dispositif d'échantillonnage (132) dans le dispositif de mesure (136), un espace d'échantillonnage (138) du dispositif de mesure (136) étant prévu à l'intérieur d'un volume (164) du tube extérieur (160), le tube extérieur (160) disposant d'un fond fermé (168) ;
- un tube intérieur (162) pour recevoir une graine de semence séparée (114), le tube intérieur (162) étant introduit dans le tube extérieur (160) et présentant une ouverture inférieure (166), de sorte que la graine de semence séparée (114) puisse être introduite dans le volume (164) du tube extérieur (160) ; et
- un espace intermédiaire (170) entre le tube extérieur (160) et le tube intérieur (162), l'espace intermédiaire (170) étant réalisé de telle sorte que la graine de semence séparée (114) puisse être déchargée de manière pneumatique hors du tube extérieur (160) à travers le tube intérieur (162) dans un dispositif de réception (146, 200) pour une graine de semence classée (114).

2. Dispositif d'échantillonnage (132) selon la revendication précédente, comprenant en outre un dispositif d'ajustement (180) pour exécuter une commande entre l'entrée (186) pour la graine de semence séparée (114) et une sortie (188) vers le dispositif de réception (146, 200) pour la graine de semence classée (114).

3. Dispositif d'échantillonnage (132) selon la revendication précédente, dans lequel un rideau d'air (182) est prévu pour commander le dispositif d'ajustement (180).

4. Dispositif d'échantillonnage (132) selon l'une quelconque des revendications précédentes, dans lequel l'espace d'échantillonnage (138) se trouve de manière centrée au-dessus du fond (168) du tube extérieur (160) et dans lequel le tube intérieur (162) est introduit de manière centrée dans le tube extérieur (160), de sorte que la graine de semence séparée (114) puisse être introduite de manière centrée dans le volume (164) du tube extérieur (160).

5. Dispositif d'échantillonnage (132) selon l'une quelconque des revendications précédentes, comprenant en outre un dispositif de raccordement (172) pour recevoir le tube extérieur (160), le tube intérieur (162) ainsi qu'une entrée (174) et une sortie (176) pour un échange d'air, le dispositif de raccordement (172) étant configuré de telle sorte qu'il se forme de ce fait un espace intermédiaire annulaire (170) entre le tube extérieur (160) et le tube intérieur (162).

6. Système (110) pour classer une pluralité (112) de graines de semence (114), comprenant
- au moins un dispositif de séparation (120) pour séparer des graines de semences (114) à partir d'une pluralité (112) de graines de semences fournies (114) ;
- au moins un dispositif d'échantillonnage (132) selon l'une quelconque des revendications précédentes pour introduire la graine de semence séparée (114) dans un dispositif de mesure (136) qui peut être utilisé pour classer la graine de semence séparée (114) ;
- au moins un dispositif de remplissage (198, 210) pour introduire la graine de semence classée (114) dans un dispositif de réception (146, 200) ; et
- au moins un dispositif de transport (118, 124, 134, 144, 152) pour transporter au moins en partie pneumatiquement la graine de semence (114) hors d'un stock (116) dans le dispositif de séparation (120), hors du dispositif de séparation (120) dans le dispositif d'échantillonnage (132) et hors du dispositif d'échantillonnage (132) dans le dispositif de réception (146, 200).

7. Système (110) selon la revendication précédente, comprenant en outre un dispositif de commande électronique (154) pour commander le transport de la graine de semence (114).

8. Système (110) selon l'une quelconque des deux revendications précédentes, dans lequel le dispositif de réception (146) comprend au moins deux récipients (148) prévus pour recevoir l'au moins une graine de semence classée (114), les récipients (148) étant disposés l'un à côté de l'autre, la graine de semence classée (114) pouvant être introduite dans un récipient sélectionné (148) au moyen d'un dispositif de pivotement (150).

9. Système (110) selon l'une quelconque des trois revendications précédentes, dans lequel le dispositif de réception (200) comprend un dépôt (202) pour recevoir les graines de semences classées (114), le dépôt (202) disposant d'une pluralité de renfoncements (206) pour recevoir exactement une graine de semence classée (114), chaque renfoncement (206) étant affecté d'un numéro spécifique, la graine de semence classée (114) pouvant être introduite au moyen du dispositif de remplissage (198, 210) dans un renfoncement sélectionné (206).

10. Système (110) selon l'une quelconque des quatre revendications précédentes, comprenant en outre un dispositif de pesée (126) pour déterminer un poids d'une graine de semence séparée (114), le dispositif de transport (124, 134) étant en outre prévu pour transporter la graine de semence (114) dans le dispositif de pesée (126) et hors du dispositif de pesée (126).

11. Procédé pour classer une pluralité (112) de graines de semence (114), comprenant les étapes de procédé suivantes :
a) séparation des graines de semence (114) à partir d'une pluralité (112) de graines de semences fournies (114) ;
b) introduction de la graine de semence séparée (114) dans un dispositif d'échantillonnage (132), le dispositif d'échantillonnage (132) étant prévu pour introduire une graine de semence séparée (114) dans un dispositif de mesure (136) qui peut être utilisé pour classer la graine de semence séparée (114), selon l'une quelconque des revendications précédentes concernant le dispositif d'échantillonnage (132), et classement de la graine de semence séparée (114) ;
c) détermination d'un poids d'une graine de semence séparée (114), les graines de semences séparées (114) étant acheminées à chaque fois mécaniquement et individuellement à un dispositif de pesée (126) pour déterminer un poids de la graine de semence séparée (114), le dispositif de pesée (126) étant une balance de précision (130) ; et
d) introduction de la graine de semence classée (114) au moyen d'un dispositif de remplissage (198, 210) dans un dispositif de réception (146, 200) ;
la graine de semence (114) étant transportée au moins en partie de manière pneumatique hors d'un stock successivement jusqu'à différents dispositifs qui sont prévus à chaque fois pour effectuer l'une des étapes de procédé, et l'étape de procédé c) étant effectuée après l'étape de procédé a) et avant l'étape de procédé d).

12. Procédé selon la revendication précédente, dans lequel la graine de semence (114) est tout d'abord guidée sur une plaque plane, un transport de la graine de semence séparée (114) sur la plaque plane s'effectuant par le biais d'un déplacement latéral mécanique de la graine de semence (114) sur la surface de la plaque plane.

13. Procédé selon la revendication précédente, dans lequel la plaque plane dispose dans ce cas d'au moins deux ouvertures, une première ouverture étant prévue pour le dispositif de pesée (126) et une ouverture supplémentaire étant prévue pour l'acheminement jusqu'à l'entrée dans le dispositif d'échantillonnage (132).

14. Programme informatique prévu pour commander un système selon la revendication 7 de manière à ce qu'il exécute les étapes du procédé selon la revendication 11.

15. Utilisation d'un système (110) selon l'une quelconque des revendications précédentes concernant le système (110) pour un classement à haut rendement automatisé de graines de semences (114), y compris d'objets en forme de pilules, en utilisant un dispositif de mesure (136) qui est prévu pour étudier les graines de semences (114) au moyen d'un procédé de résonance magnétique nucléaire (140) et/ou d'un procédé de mesure optique, ou pour un contrôle de qualité de graines de semences ou de pilules dans l'industrie pharmaceutique.
